# EUROPEAN PATENT SPECIFICATION

(11) **EP 3 879 279 B1**
(45) Date of publication and mention of the grant of the patent: **25.12.2024**
(21) Application number: 19881902.1
(22) Date of filing: 23.05.2019
(51) Int. Cl.: G01R 27/08, G01R 31/66

(54) **IMPEDANCE MEASUREMENT DEVICE**
IMPEDANZMESSVORRICHTUNG
DISPOSITIF DE MESURE DE L'IMPÉDANCE

(30) Priority: 06.11.2018 JP 2018208837
(43) Date of publication of application: 15.09.2021
(73) Proprietor: Hioki E.E. Corporation, Ueda-shi, Nagano 386-1192 (JP)
(72) Inventor: IIJIMA Junji, Ueda-shi Nagano 386-1192 (JP)
(74) Representative: Vossius & Partner Patentanwälte Rechtsanwälte mbB
(86) International application number: PCT/JP2019/020440
(87) International publication number: WO 2020/095471

(56) References cited:
- JP-A- 2003 180 647
- JP-A- 2006 322 821
- JP-A- 2006 322 821
- JP-A- 2007 178 257
- JP-A- 2015 032 209
- US-A- 5 416 470

## Description

### Technical Field

The present invention relates to a four-wire impedance measuring apparatus that has a pair of source terminals (that is, terminals that supply current) and a pair of sensing terminals (that is, terminals that detect a voltage) connected to a measurement object, that is, an impedance measuring apparatus that measures impedance using a four-terminal method.

### Background Art

As examples of this type of impedance measuring apparatus, the various impedance measuring apparatuses disclosed in Patent Document 1 cited below are known. One of these impedance measuring apparatuses is an impedance measuring apparatus including: a measurement signal source that supplies an alternating current (AC) measurement signal to the measurement object (or "measurement sample") via the source terminals on the Hi side and Lo side for supplying a signal; a meter that measures the voltage generated in the measurement object by this measurement signal via sensing terminals provided on the Hi side and Lo side for detecting a signal; a first broken connection detecting means for detecting the connection state between the measurement object and both the source terminal on the Hi side and the sensing terminal on the Hi side; and a second broken connection detecting means for detecting the connection state between the measurement object and both the source terminal on the Lo side and the sensing terminal on the Lo side. The first broken connection detecting means includes a first direct current (DC) constant current source, which supplies a DC constant current to a Hi side current path including the source terminal on the Hi side and the sensing terminal on the Hi side, and a first comparator, which compares the amplitude of the first DC constant current source and a predetermined first reference voltage and outputs a determination signal. The second broken connection detecting means includes a second DC constant current source, which supplies a DC constant current to a Lo side current path including the source terminal on the Lo side and the sensing terminal on the Lo side, and a second comparator, which compares the amplitude of the second DC constant current source and a predetermined second reference voltage and outputs a determination signal.

Another impedance measuring apparatus includes: a measurement signal source that supplies an AC measurement signal to a measurement object (or "measured sample") via source terminals on the Hi side and Lo side for supplying a signal; and a meter that measures the voltage generated in the measurement object from this measurement signal via sensing terminals on the Hi side and Lo side for detecting a signal. In this impedance measuring apparatus, the measuring signal source and the meter have separate power supply systems that are electrically separated from the ground. The meter is equipped with a broken connection-detection AC constant current source that supplies an AC constant current for detecting broken connections between the sensing terminal on the Hi side and the sensing terminal on the Lo side, and a voltage detecting means that detects the voltage generated at the respective sensing terminals by the AC constant current used to detect broken connections.

According to the former impedance measuring apparatus out of the impedance measuring apparatuses described above, by including the first broken connection detecting means and the second broken connection detecting means of the configuration described above, it is possible, even during measurement, to detect broken connections for the respective terminals (that is, detection of the connection state between the measurement object and both the source terminal on the Hi side and the sensing terminal on the Hi side and detection of the connection state between the measurement object and both the source terminal on the Lo side and the sensing terminal on the Lo side). According to the former impedance measuring apparatus, by including the AC constant current source for detecting broken connections and the voltage detecting means of the configuration described above, it is also possible, even during measurement, to detect broken connections for the respective terminals (that is, detection of the connection states between the measurement object and both the sensing terminal on the Hi side and the sensing terminal on the Lo side).

### Citation List

### Patent Literature

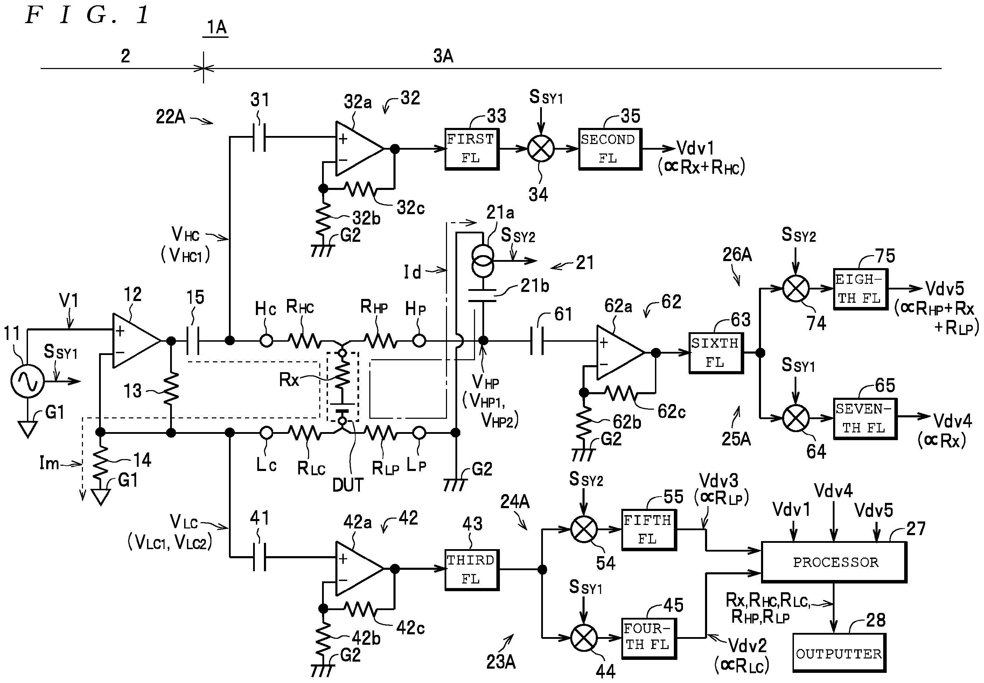

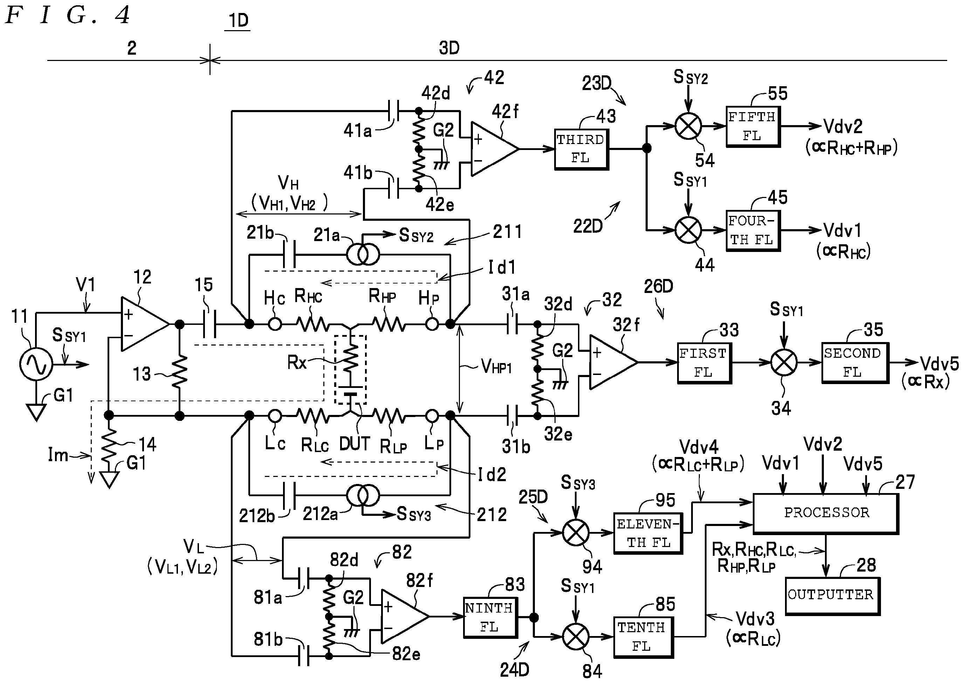

Patent Literature 1
Japanese Laid-open Patent Publication No. 2006-322821 (see pages 7 to 9 and FIGS. 1 and 4)

### Summary of Invention

### Technical Problem

However, although the two impedance measuring apparatuses described above are capable of detecting the connection states between the measurement object and a pair of terminals as a whole, there is a problem to be solved that neither of the two impedance measuring apparatuses is capable of detecting the individual connection states between each terminal in a pair of terminals and the measurement object.

The present invention was conceived in view of the above problem and has a principal object of providing an impedance measuring apparatus capable of individually measuring (detecting) contact resistances which indicate individual connection states between the measurement object and a source terminal on the Hi side, a sensing terminal on the Hi side, a source terminal on the Lo side, and a sensing terminal on the Lo side.

### Solution to Problem

To achieve the stated object, the invention provides an impedance measuring apparatus according to any one of independent claims 1 to 3.

Also, preferably, a frequency of the AC measurement current and a frequency of the AC test current are set at respectively different values.

Also, the invention provides an impedance measuring apparatus according to claim 5.

Also, preferably, a frequency of the AC measurement current is set at a different value to a frequency of the first AC test current and a frequency of the second AC test current.

### Advantageous Effects of Invention

According to the impedance measuring apparatuses according to claims 1, 2, and 3, the first ground for the measuring signal source and the second ground for the meter are electrically separated and by including, in addition to the detector for detecting (measuring) the impedance of the measurement object, the test signal source and the detector for detecting (measuring) the contact resistances, it is possible to individually measure the contact resistances between the source terminals on the Hi side and Lo side for supplying signals and the sensing terminals on the Hi side and Lo side for detecting signals and the corresponding electrodes of the measurement object.

Also, according to the impedance measuring apparatus according to claim 4, by setting the frequency of the AC measurement current and the frequency of the AC test current at different values, it is possible to measure the impedance of the measurement object and the respective contact resistances by supplying the AC measurement current from the measurement signal source to the measurement object and supplying the AC test current from the test signal source to the measurement object at the same time, which makes it possible to shorten the measurement time.

According to the impedance measuring apparatuses according to claim 5, the first ground for the measuring signal source and the second ground for the meter are electrically separated and by including, in addition to the detector for detecting (measuring) the impedance of the measurement object, the first test signal source, the second test signal source, and the detector for detecting (measuring) the contact resistances, it is possible to individually measure the contact resistances between the source terminals on the Hi side and Lo side for supplying signals and the sensing terminals on the Hi side and Lo side for detecting signals and the corresponding electrodes of the measurement object.

Also, according to the impedance measuring apparatus according to claim 6, by setting the frequency of the AC measurement current, the frequency of the first AC test current, and the frequency of the second AC test current at respectively different values, it is possible to measure the impedance of the measurement object and the respective contact resistances by supplying the AC measurement current from the measurement signal source to the measurement object and supplying the AC test currents from the two test signal sources to the measurement object at the same time, which makes it possible to shorten the measurement time.

### Brief Description of Drawings

FIG. 1
   FIG. 1 is a block diagram depicting the configuration of an impedance measuring apparatus 1A.
FIG. 2

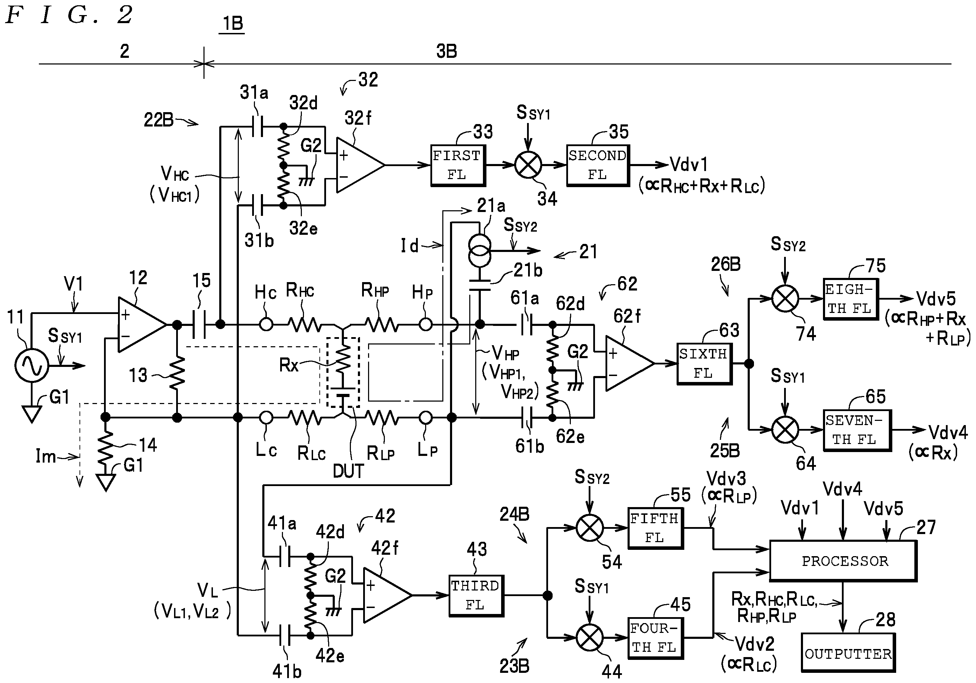

   FIG. 2 is a block diagram depicting the configuration of an impedance measuring apparatus 1B.
FIG. 3

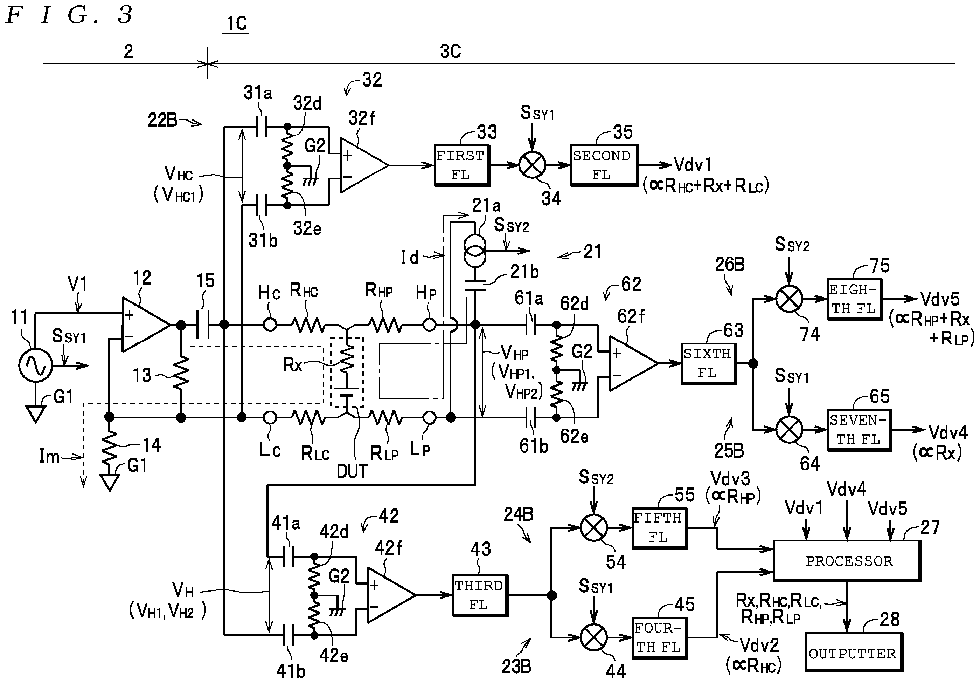

   FIG. 3 is a block diagram depicting the configuration of an impedance measuring apparatus 1C.
FIG. 4
   FIG. 4 is a block diagram depicting the configuration of an impedance measuring apparatus 1D.

### Description of Embodiments

Preferred embodiments of an impedance measuring apparatus will now be described with reference to the attached drawings.

First, the configuration of an impedance measuring apparatus 1A as an example of an impedance measuring apparatus according to the present invention will be described with reference to FIG. 1.

The impedance measuring apparatus 1A includes a source terminal Hc (a source terminal for supplying a measurement signal) on a Hi side, a source terminal Lc (a source terminal for supplying a measurement signal) on a Lo side, a Hi side sensing terminal Hp (a sensing terminal for detecting a signal), a Lo side sensing terminal Lp (a sensing terminal for detecting a signal), a measurement signal source 2, and a meter 3A. The impedance measuring apparatus 1A is configured so as to be capable of measuring impedance of a measurement object DUT in a state where the source terminal Hc on the Hi side and the sensing terminal Hp on the Hi side are connected to one electrode of the measurement object DUT (as one example, the terminals are connected via measurement cables (not illustrated)) and the source terminal Lc on the Lo side and the sensing terminal Lp on the Lo side are connected to the other electrode of the measurement object DUT (as one example, the terminals are connected via measurement cables (not illustrated)). As one example in the present embodiment, it is assumed that for the impedance measuring apparatus 1A, the measurement object DUT is a battery and an internal resistance Rx of the battery is to be measured as the "impedance" in a state where the source terminal Hc on the Hi side and the sensing terminal Hp on the Hi side are connected to the positive electrode of the battery as the measurement object DUT and the source terminal Lc on the Lo side and the sensing terminal Lp on the Lo side are connected to the negative electrode of the battery.

The measurement signal source 2 supplies an AC measurement current Im (with the frequency f1) to the measurement object DUT that is connected between the source terminals Hc and Lc on the Hi side and the Lo side. As one example, the measurement signal source 2 includes an AC signal source 11, an operational amplifier 12, a feedback resistor 13, a ground resistor 14, and a coupling capacitor 15. The measurement signal source 2 operates based on a DC voltage (that is, a DC voltage (a DC positive voltage and a DC negative voltage) with the potential of a first ground G1 as a reference) supplied from a power supply system (hereinafter, also referred to as the "first power supply system"), not illustrated, for the measurement signal source 2.

The AC signal source 11 outputs an AC signal V1 (a sinusoidal voltage signal) with a constant (known) amplitude and a constant frequency f1. The AC signal source 11 also outputs a synchronization signal S_{SY1} with a frequency f1 that is synchronized with the AC signal V1. The operational amplifier 12 has the feedback resistor 13 connected between the output terminal and the inverting input terminal. The inverting input terminal of the operational amplifier 12 is connected to the first ground G1 via the ground resistor 14. The operational amplifier 12 amplifies and outputs the AC signal V1 inputted into the non-inverting input terminal. The output terminal of the operational amplifier 12 is connected to the source terminal Hc via the coupling capacitor 15, and the inverting input terminal is connected to the source terminal Lc. With this configuration, the operational amplifier 12 is capable of supplying an AC constant current of a known current value obtained by dividing the voltage value of the AC signal V1 by the resistance value of the ground resistance 14 as an AC measurement current Im to the measurement object DUT connected between the source terminals Hc and Lc. As described later, since the first ground G1, which is the reference for the DC voltage described above (the DC positive voltage and DC negative voltage for operation) used by the measurement signal source 2, is electrically separated from a second ground G2, which is the reference for a DC voltage (the DC positive voltage and DC negative voltage for operation) used by the meter 3A, as depicted in FIG. 1, the AC measurement current Im flows only on a path from the output terminal of the operational amplifier 12 via the coupling capacitor 15, the source terminal Hc, the measurement object DUT, the source terminal Lc, and the ground resistance 14 to the first ground G1. Note that since the measurement object DUT in the present embodiment is a battery that generates a DC electromotive force, the coupling capacitor 15 is provided to avoid a situation where the DC electromotive force is applied to the output terminal of the operational amplifier 12. Accordingly, when the measurement object DUT is not a measurement object that generates a DC electromotive force, it is possible to use a configuration where the output terminal of the operational amplifier 12 is directly connected to the source terminal Hc without the coupling capacitor 15 being provided.

The meter 3A includes a test signal source 21, a first detector 22A, a second detector 23A, a third detector 24A, a fourth detector 25A, a fifth detector 26A, a processor 27, and an outputter 28. The meter 3A measures, along with the internal resistance Rx of the measurement object DUT, the contact resistance R_{HC} between the source terminal Hc on the Hi side and the positive electrode of the measurement object DUT, the contact resistance R_{LC} between the source terminal Lc on the Lo side and the negative electrode of the measurement object DUT, the contact resistance R_{HP} between the sensing terminal Hp on the Hi side and the positive electrode of the measurement object DUT, and the contact resistance R_{LP} between the sensing terminal Lp on the Lo side and the negative electrode of the measurement object DUT. The "contact resistances" R_{HC}, R_{LC}, R_{HP}, and R_{LP} may refer to the actual contact resistances themselves, or the concept may include, in addition to the actual contact resistances, resistances of wiring (that is, the resistance of the measurement cables) from the corresponding electrode out of the positive electrode and the negative electrode to the corresponding terminal out of the terminals Hc, Lc, Hp, and Lp. The meter 3A operates based on a DC voltage (a DC voltage (that is, a DC positive voltage and a DC negative voltage) that has the potential of the second ground G2 that is electrically separated from the first ground G1 as a reference), which is supplied from a power supply system, not illustrated, for the meter 3A (a separate power supply system that is electrically separated from the first power supply system described above, and also referred to hereinafter as the "second power supply system").

The test signal source 21 includes an AC signal source 21a and a coupling capacitor 21b. The AC signal source 21a is connected between the sensing terminal Hp and the sensing terminal Lp connected to the second ground G2 in a state where the AC signal source 21a is connected in series with the coupling capacitor 21b. The AC signal source 21a supplies a sinusoidal constant current that has a constant (known) current value and a constant frequency f2 (a frequency that differs to the frequency f1) as an AC test current Id to the measurement object DUT. As described above, since the second ground G2 which is the reference of the DC voltage used by the meter 3A is electrically separated from the first ground G1 which is the reference of the DC voltage used by the measurement signal source 2, as depicted in FIG. 1, the AC test current Id flows only on a path that passes from the AC signal source 21a via the coupling capacitor 21b, the sensing terminal Hp, the measurement object DUT, and the sensing terminal Lp before returning to the AC signal source 21a. The AC signal source 21a also outputs a synchronization signal S_{SY2} whose frequency f2 is synchronized with the AC test current Id. Note that in the present embodiment, a coupling capacitor 21b is provided to avoid a situation where the DC electromotive force outputted from the measurement object DUT is applied across the output terminals of the AC signal source 21a. Accordingly, when the measurement object DUT does not generate a DC electromotive force, it is possible to use a configuration where the AC signal source 21a is directly connected across the sensing terminals Hp and Lp without the coupling capacitor 21b being provided.

The first detector 22A is connected to the source terminal Hc on the Hi side, detects, with reference to the second ground G2, a voltage (a sinusoidal voltage signal) V_{HC1} generated at the source terminal Hc based on the AC measurement current Im flowing on a path from the source terminal Hc via the source terminal Lc on the Lo side to the first ground G1, and outputs a first detection voltage Vdv1, which is a DC voltage whose voltage value changes according to the voltage value (for example, the amplitude) of the voltage V_{HC1}.

As one example, the first detector 22A includes a coupling capacitor 31, a first amplifier 32, a first filter (indicated as the "first FL" in FIG. 1) 33, a detection circuit 34, and a second filter (indicated as the "second FL" in FIG. 1) 35.

One end of the coupling capacitor 31 is connected to the source terminal Hc. The coupling capacitor 31 is provided to avoid a situation where the DC electromotive force of the measurement object DUT is applied to the non-inverting input terminal of an operational amplifier 32a, described later, that constructs the first amplifier 32. Accordingly, when the measurement object DUT does not generate a DC electromotive force, it is possible to use a configuration where the non-inverting input terminal of the operational amplifier 32a is directly connected to the source terminal Hc without the coupling capacitor 31 being provided.

The first amplifier 32 is constructed of the operational amplifier 32a that functions as a non-inverting amplifier, whose non-inverting input terminal is connected to the other end of the coupling capacitor 31, whose inverting input terminal is connected via an input resistor 32b to the second ground G2, and which has a feedback resistor 32c connected between the output terminal and the inverting input terminal. With this configuration, the first amplifier 32 inputs an AC voltage V_{HC} (a voltage that includes the voltage V_{HC1} as a voltage component) generated at the source terminal Hc via the coupling capacitor 31, amplifies by a specified amplification factor, and outputs as an amplified signal.

The first filter 33 is constructed as a narrow bandpass filter that mainly passes signal components with the same frequency as the frequency f1 of the AC measurement current Im (which is also the frequency of the AC signal V1). By using this configuration, the first filter 33 inputs the amplified signal outputted from the first amplifier 32, removes frequency components (noise components) outside the pass band which are included in the amplified signal, and outputs the resulting signal.

As one example, the detection circuit 34 is constructed using a multiplier and, by multiplying the signal outputted from the first filter 33 and the synchronization signal S_{SY1} outputted from the AC signal source 11 (or in other words, by synchronously detecting the signal outputted from the first filter 33 using the synchronization signal S_{SY1}), outputs a DC signal whose voltage value changes according to the voltage value (for example, the amplitude) of the voltage component based on the AC measurement current Im (that is, the voltage V_{HC1}), out of the voltage components that compose the voltage V_{HC}. The second filter 35 is constructed as a low-pass filter, inputs the DC signal outputted from the detection circuit 34, removes the AC component, and performs smoothing to output the first detection voltage Vdv1.

Here, since the first detection voltage Vdv1 is a voltage obtained by detecting, with reference to the second ground G2, the voltage V_{HC1} generated at the source terminal Hc based on the AC measurement current Im, the voltage value of the first detection voltage Vdv1 takes a value (∝Rx+R_{HC}) that is proportional to the combined series resistance (Rx+R_{HC}) of the internal resistance Rx and the contact resistance R_{HC}. For this reason, the combined series resistance (Rx+R_{HC}) is calculated by dividing the voltage value of the first detection voltage Vdv1 by the known current value of the AC measurement current Im.

The second detector 23A is connected to the source terminal Lc on the Lo side, detects, with reference to the second ground G2, a voltage (a sinusoidal voltage signal) V_{LC1} generated at the source terminal Lc based on the AC measurement current Im, and outputs a second detection voltage Vdv2, which is a DC voltage whose voltage value changes according to the voltage value (for example, the amplitude) of the voltage V_{LC1}.

As one example, the second detector 23A includes a coupling capacitor 41, a second amplifier 42, a third filter (indicated as the "third FL" in FIG. 1) 43, a detection circuit 44, and a fourth filter (indicated as the "fourth FL" in FIG. 1) 45.

One end of the coupling capacitor 41 is connected to the source terminal Lc. The coupling capacitor 41 is provided to avoid a situation where the DC electromotive force of the measurement object DUT is applied to the non-inverting input terminal of an operational amplifier 42a, described later, which constructs the second amplifier 42. Accordingly, when the measurement object DUT does not generate a DC electromotive force, it is possible to use a configuration where the non-inverting input terminal of the operational amplifier 42a is directly connected to the source terminal Lc without the coupling capacitor 41 being provided.

The second amplifier 42 is constructed of the operational amplifier 42a that functions as a non-inverting amplifier, whose non-inverting input terminal is connected to the other end of the coupling capacitor 41, whose inverting input terminal is connected via an input resistor 42b to the second ground G2, and which has a feedback resistor 42c connected between the output terminal and the inverting input terminal. With this configuration, the second amplifier 42 inputs the AC voltage V_{LC} (a voltage which includes the voltage V_{LC1} and a voltage V_{LC2} described later as voltage components) generated at the source terminal Lc via the coupling capacitor 41, amplifies at a specified amplification factor, and outputs as an amplified signal.

The third filter 43 is constructed as a narrow bandpass filter that mainly passes signal components in a frequency band including the frequency f1 of the AC measurement current Im and the frequency f2 of the AC test current Id. By using this configuration, the third filter 43 inputs the amplified signal outputted from the second amplifier 42, removes frequency components (noise components) outside the pass band that are included in the amplified signal, and outputs the resulting signal.

As one example, the detection circuit 44 is constructed using a multiplier, and by multiplying the signal outputted from the third filter 43 and the synchronization signal S_{SY1} (or in other words, by synchronously detecting the signal outputted from the third filter 43 using this synchronization signal S_{SY1}), outputs a DC signal whose voltage value changes according to the voltage value (for example, the amplitude) of the voltage component (the voltage V_{LC1}) based on the AC measurement current Im, out of the voltage components that compose the voltage V_{LC}. The fourth filter 45 is configured as a low-pass filter, inputs the DC signal outputted from the detection circuit 44, removes the AC component, and performs smoothing to output the second detection voltage Vdv2.

Here, since the second detection voltage Vdv2 is a voltage obtained by detecting, with reference to the second ground G2, the voltage V_{LC1} generated at the source terminal Lc based on the AC measurement current Im, the voltage value of the second detection voltage Vdv2 is a value (∝R_{LC}) that is proportional to the contact resistance R_{LC}. For this reason, the contact resistance R_{LC} is calculated by dividing the voltage value of the second detection voltage Vdv2 by the known current value of the AC measurement current Im.

The third detector 24A is connected to the source terminal Lc on the Lo side, detects, with reference to the second ground G2, a voltage (a sinusoidal voltage signal) V_{LC2} generated at the source terminal Lc based on the AC test current Id, and outputs a voltage Vdv3, which is a DC voltage whose voltage value changes according to the voltage value (for example, the amplitude) of the voltage V_{LC2}.

As one example, the third detector 24A includes the coupling capacitor 41, the second amplifier 42, the third filter 43, a detection circuit 54, and a fifth filter (indicated as "fifth FL" in FIG. 1) 55. Although the example of the third detector 24A in the present embodiment uses a configuration where the coupling capacitor 41, the second amplifier 42, and the third filter 43 are shared with the second detector 23A to reduce the number of parts that construct the impedance measuring apparatus 1A, the impedance measuring apparatus 1A is not limited to this configuration. As examples, although not illustrated, components corresponding to the coupling capacitor 41, the second amplifier 42, and the third filter 43 may be provided for dedicated use by the third detector 24A, the coupling capacitor 41 may be shared and components corresponding to the second amplifier 42 and the third filter 43 may be provided for dedicated use by the third detector 24A, or the coupling capacitor 41 and the second amplifier 42 may be shared, and a component corresponding to the third filter 43 may be provided for dedicated use by the third detector 24A.

As one example, the detection circuit 54 is constructed using a multiplier, and by multiplying the signal outputted from the third filter 43 and the synchronization signal S_{SY2} outputted from the AC signal source 21a (or in other words, by synchronously detecting the signal outputted from the third filter 43 using this synchronization signal S_{SY2}), outputs a DC signal whose voltage value changes according to the voltage value (for example, the amplitude) of the voltage component (the voltage V_{LC2}) based on the AC test current Id, out of the voltage components that compose the voltage V_{LC}. The fifth filter 55 is constructed as a low-pass filter, inputs the DC signal outputted from the detection circuit 54, removes an AC component, and performs smoothing to output the third detection voltage Vdv3.

Here, since the third detection voltage Vdv3 is a voltage obtained by detecting, with reference to the second ground G2, the voltage V_{LC2} generated at the source terminal Lc based on the AC test current Id, the voltage value of the third detection voltage Vdv3 is a value (∝R_{LP}) that is proportional to the contact resistance R_{LP}. For this reason, the contact resistance R_{LP} is calculated by dividing the voltage value of the third detection voltage Vdv3 by the known current value of the AC test current Id.

The fourth detector 25A is connected to the sensing terminal Hp on the Hi side, detects, with reference to the second ground G2, a voltage V_{HP1} generated at the sensing terminal Hp based on the AC measurement current Im, and outputs a fourth detection voltage Vdv4, which is a DC voltage whose voltage value changes according to the voltage value (for example, the amplitude) of the voltage V_{HP1}.

As one example, the fourth detector 25A includes a coupling capacitor 61, a third amplifier 62, a sixth filter (indicated as "sixth FL" in FIG. 1) 63, a detection circuit 64, and a seventh filter (indicated as "seventh FL" in FIG. 1) 65.

One end of the coupling capacitor 61 is connected to the sensing terminal Hp. The third amplifier 62 is constructed of an operational amplifier 62a that functions as a non-inverting amplifier, whose non-inverting input terminal is connected to the other end of the coupling capacitor 61, whose inverting input terminal is connected via an input resistor 62b to the second ground G2, and which has a feedback resistor 62c connected between the output terminal and the inverting input terminal. With this configuration, the third amplifier 62 inputs the AC voltage V_{HP} (a voltage that includes the voltage V_{HP1} and a voltage V_{HP2} described later as voltage components) generated at the sensing terminal Hp via the coupling capacitor 61, amplifies at a specified amplification factor, and outputs as an amplified signal. Note that in the present embodiment, a coupling capacitor 61 is provided to avoid a situation where the DC electromotive force outputted from the measurement object DUT is applied to the input terminal of the third amplifier 62. Accordingly, when the measurement object DUT does not generate a DC electromotive force, it is also possible to use a configuration where the non-inverting input terminal of the operational amplifier 62a that constructs the third amplifier 62 is directly connected to the sensing terminal Hp without the coupling capacitor 61 being provided.

The sixth filter 63 is constructed as a narrow bandpass filter that mainly passes signal components in a frequency band including the frequency f1 of the AC measurement current Im and the frequency f2 of the AC test current Id. By using this configuration, the sixth filter 63 inputs the amplified signal outputted from the third amplifier 62, removes the frequency components (noise components) outside the pass band included in the amplified signal, and outputs the resulting signal.

As one example, the detection circuit 64 is constructed using a multiplier, and by multiplying the signal outputted from the sixth filter 63 and the synchronization signal S_{SY1} (or in other words, by synchronously detecting the signal outputted from the sixth filter 63 using this synchronization signal S_{SY1}), outputs a DC signal whose voltage value changes according to the voltage value (for example, the amplitude) of the voltage component (the voltage V_{HP1}) based on the AC measurement current Im out of the voltage components that compose the voltage V_{HP}. The seventh filter 65 is configured as a low pass filter, inputs the DC signal outputted from the detection circuit 64, removes an AC component, and performs smoothing to output a fourth detection voltage Vdv4.

Here, since the fourth detection voltage Vdv4 is a voltage obtained by detecting, with reference to the second ground G2, the voltage V_{HP1} generated at the sensing terminal Hp based on the AC measurement current Im, the voltage value is a value (∝Rx) that is proportional to the internal resistance Rx. For this reason, the internal resistance Rx is calculated by dividing the voltage value of the fourth detection voltage Vdv4 by the known current value of the AC measurement current Im.

The fifth detector 26A is connected to the sensing terminal Hp, detects, with reference to the second ground G2, the voltage (a sinusoidal voltage signal) V_{HP2} generated at the sensing terminal Hp based on the AC test current Id, and outputs a fifth detection voltage Vdv5, which is a DC voltage whose voltage value changes according to the voltage value (for example, the amplitude) of the voltage V_{HP2}.

As one example, the fifth detector 26A includes the coupling capacitor 61, the third amplifier 62, the sixth filter 63, a detection circuit 74, and an eighth filter (indicated as "eighth FL" in FIG. 1) 75. Although the example of the fifth detector 26A in the present embodiment uses a configuration where the coupling capacitor 61, the third amplifier 62, and the sixth filter 63 are shared with the fourth detector 25A to reduce the number of parts that construct the impedance measuring apparatus 1A, the impedance measuring apparatus 1A is not limited to this configuration. As examples, although not illustrated, components corresponding to the coupling capacitor 61, the third amplifier 62, and the sixth filter 63 may be provided for dedicated use by the fifth detector 26A, the coupling capacitor 61 may be shared and components corresponding to the third amplifier 62 and the sixth filter 63 may be provided for dedicated use by the fifth detector 26A, or the coupling capacitor 61 and the third amplifier 62 may be shared and a component corresponding to the sixth filter 63 may be provided for dedicated use by the fifth detector 26A.

As one example, the detection circuit 74 is constructed using a multiplier, and by multiplying the signal outputted from the sixth filter 63 and the synchronization signal S_{SY2} outputted from the AC signal source 21a (or in other words, by synchronously detecting the signal outputted from the sixth filter 63 using this synchronization signal S_{SY2}), outputs a DC signal whose voltage value changes according to the voltage value (for example, the amplitude) of the voltage component (the voltage V_{HP2}) based on the AC test current Id out of the voltage components that compose the voltage V_{HP}. The eighth filter 75 is constructed as a low-pass filter, inputs the DC signal outputted from the detection circuit 74, removes the AC component and performs smoothing to output a fifth detection voltage Vdv5.

Here, since the fifth detection voltage Vdv5 is a voltage obtained by detecting, with reference to the second ground G2, the voltage V_{HP2} generated at the sensing terminal Hp based on the AC test current Id, the voltage value is a value (∝R_{HP}+Rx+R_{LP}) that is proportional to the combined series resistance (R_{HP}+Rx+R_{LP}) of the contact resistance R_{HP}, the internal resistance Rx, and the contact resistance R_{LP}. For this reason, the combined series resistance (R_{HP}+Rx+R_{LP}) is calculated by dividing the voltage value of the fifth detection voltage Vdv5 by the known current value of the AC test current Id.

As one example, the processor 27 includes an A/D converter, a CPU, and a memory (none of which are illustrated), and executes an impedance measuring process. In this impedance measuring process, the processor 27 inputs the first detection voltage Vdv1, the second detection voltage Vdv2, the third detection voltage Vdv3, the fourth detection voltage Vdv4, and the fifth detection voltage Vdv5, calculates the respective voltage values, and calculates (measures) the internal resistance Rx and the contact resistances R_{HC}, R_{LC}, R_{HP}, and R_{LP} based on these voltage values and the known current values of the AC measurement current Im and the AC test current Id. The processor 27 also executes an output process for outputting the calculated internal resistance Rx and the respective contact resistances R_{HC}, R_{LC}, R_{HP}, and R_{LP} to the outputter 28.

As one example, the outputter 28 is constructed of a display device, and displays (outputs) the internal resistance Rx and the respective contact resistances R_{HC}, R_{LC}, R_{HP}, R_{LP} outputted from the processor 27 on a screen. Note that it is also possible to construct the outputter 28 of various interface circuits in place of the display apparatus. When the outputter 28 is constructed by an external interface circuit, the internal resistance Rx and the respective contact resistances R_{HC}, R_{LC}, R_{HP}, and R_{LP} are outputted via the external interface circuit to an external apparatus connected on a transmission path. When the outputter 28 is constructed of an interface circuit for a medium, the internal resistance Rx and the respective contact resistances R_{HC}, R_{LC}, R_{HP}, and R_{LP} are stored in a storage medium connected to the interface circuit for the medium.

Next, the operation of the impedance measuring apparatus 1A will be described with reference to the drawings. Note that it is assumed that the impedance measuring apparatus 1A has been connected to the measurement object DUT (a battery) via four measurement cables, not illustrated.

With the impedance measuring apparatus 1A, the measurement signal source 2 supplies an AC measurement current Im (with the frequency f1) to the measurement object DUT that is connected between the source terminal Hc and sensing terminal Hp pair and the source terminal Lc and sensing terminal Lp pair and the test signal source 21 of the meter 3A supplies the AC test current Id (with the frequency f2) to the measurement object DUT.

In this state, in the meter 3A, the first detector 22A detects, with reference to the second ground G2, the voltage V_{HC1} included in the AC voltage V_{HC} generated at the source terminal Hc and outputs the first detection voltage Vdv1 whose voltage value changes according to the voltage value of the voltage V_{HC1}. The second detector 23A detects, with reference to the second ground G2, the voltage V_{LC1} included in the AC voltage V_{LC} generated at the source terminal Lc and outputs the second detection voltage Vdv2 whose voltage value changes according to the voltage value of the voltage V_{LC1}. The third detector 24A detects, with reference to the second ground G2, the voltage V_{LC2} included in the AC voltage V_{LC} generated at the source terminal Lc and outputs the third detection voltage Vdv3 whose voltage value changes according to the voltage value of the voltage V_{LC2}. The fourth detector 25A detects, with reference to the second ground G2, the voltage V_{HP1} included in the AC voltage V_{HP} generated at the sensing terminal Hp and outputs the fourth detection voltage Vdv4 whose voltage value changes according to the voltage value of the voltage V_{HP1}. The fifth detector 26A detects, with reference to the second ground G2, the voltage V_{HP2} included in the AC voltage V_{HP} generated at the sensing terminal Hp and outputs the fifth detection voltage Vdv5 whose voltage value changes according to the voltage value of the voltage V_{HP2}.

The processor 27 executes the impedance measuring process based on the detection voltages Vdv1, Vdv2, Vdv3, Vdv4, and Vdv5 outputted from the detectors 22A, 23A, 24A, 25A, and 26A. In this impedance measuring process, the processor 27 first performs A/D conversion on the detection voltages Vdv1, Vdv2, Vdv3, Vdv4, and Vdv5 to convert to voltage data that indicates the voltage values of the detection voltages Vdv1, Vdv2, Vdv3, Vdv4, and Vdv5. After this, the processor 27 detects the voltage values of the respective detection voltages Vdv1, Vdv2, Vdv3, Vdv4, and Vdv5 based on the voltage data for the respective detection voltages Vdv1, Vdv2, Vdv3, Vdv4, and Vdv5.

Here, as described above, the voltage value of the first detection voltage Vdv1 for the voltage V_{HC1} generated at the source terminal Hc based on the AC measurement current Im is a value that is proportional to the combined series resistance (Rx+R_{HC}) of the internal resistance Rx and the contact resistance R_{HC}. The voltage value of the second detection voltage Vdv2 for the voltage V_{LC1} generated at the source terminal Lc based on the AC measurement current Im is a value that is proportional to the contact resistance R_{LC}. The voltage value of the third detection voltage Vdv3 for the voltage V_{LC2} generated at the source terminal Lc based on the AC test current Id is a value that is proportional to the contact resistance R_{LP}. The voltage value of the fourth detection voltage Vdv4 for the voltage V_{HP1} generated at the sensing terminal Hp based on the AC measurement current Im is a value that is proportional to the internal resistance Rx. The voltage value of the fifth detection voltage Vdv5 for the voltage V_{HP2} generated at the sensing terminal Hp based on the AC test current Id is a value that is proportional to the combined series resistance (R_{HP}+Rx+R_{LP}) of the contact resistance R_{HP}, the internal resistance Rx, and the contact resistance R_{LP}.

Next, the processor 27 calculates the combined series resistance (Rx+R_{HC}) by dividing the voltage value of the first detection voltage Vdv1 by the known current value of the AC measurement current Im, calculates the contact resistance R_{LC} by dividing the voltage value of the second detection voltage Vdv2 by the known current value of the AC measurement current Im, calculates the contact resistance R_{LP} by dividing the voltage value of the third detection voltage Vdv3 by the known current value of the AC test current Id, calculates the internal resistance Rx by dividing the voltage value of the fourth detection voltage Vdv4 by the known current value of the AC measurement current Im, and calculates the combined series resistance (R_{HP}+Rx+R_{LP}) by dividing the voltage value of the fifth detection voltage Vdv5 by the known current value of the AC test current Id.

After this, the processor 27 calculates the contact resistance R_{HC} by subtracting the calculated internal resistance Rx from the calculated combined series resistance (Rx+R_{HC}). The processor 27 also calculates the contact resistance R_{HP} by subtracting the calculated internal resistance Rx and the contact resistance R_{LP} from the calculated combined series resistance (R_{HP}+Rx+R_{LP}) . By doing so, all four contact resistances R_{HC}, R_{LC}, R_{HP}, and R_{LP} are calculated. The processor 27 also stores the calculated internal resistance Rx and the calculated contact resistances R_{HC}, R_{LC}, R_{HP}, and R_{LP}.

Finally, the processor 27 executes the output process and has the outputter 28 display the calculated internal resistance Rx and the respective contact resistances R_{HC}, R_{LC}, R_{HP}, and R_{LP}. By doing so, measurement of the internal resistance Rx and the contact resistances R_{HC}, R_{LC}, R_{HP}, and R_{LP} by the impedance measuring apparatus 1A is completed.

In this way, according to the impedance measuring apparatus 1A, the first ground G1 for the measuring signal source 2 and the second ground G2 for the meter 3A are electrically separated and by including, in addition to the fourth detector 25A for detecting (measuring) the internal resistance Rx, the test signal source 21, the first detector 22A, the second detector 23A, the third detector 24A, and the fifth detector 26A for detecting (measuring) the respective contact resistances R_{HC}, R_{LC}, R_{HP}, and R_{LP}, it is possible to individually measure the contact resistances R_{HC}, R_{LC}, R_{HP}, and R_{LP} between the source terminal Hc, the source terminal Lc, the sensing terminal Hp, and the sensing terminal Lp and the corresponding electrodes of the measurement object DUT. This means that according to the impedance measuring apparatus 1A, it is possible to individually detect the contact states between the source terminal Hc, the source terminal Lc, the sensing terminal Hp, and the sensing terminal Lp and the corresponding electrodes of the measurement object DUT based on the measured individual contact resistances R_{HC}, R_{LC}, R_{HP}, and R_{LP}. Therefore, according to the impedance measuring apparatus 1A, it is possible to check for the occurrence of broken connections for the measuring cables connecting the source terminal Hc, the source terminal Lc, the sensing terminal Hp, and the sensing terminal Lp and the corresponding electrode of the measurement object DUT, the progress of wear at the tips (contacts) of the measuring cables that come into contact with the measurement object DUT, and the like separately for each measuring cable.

Next, an impedance measuring apparatus 1B as an example of another impedance measuring apparatus according to the present invention will be described with reference to FIG. 2. Note that component elements that are the same as the impedance measuring apparatus 1A described above have been assigned the same reference numerals and duplicated description is omitted.

The impedance measuring apparatus 1B includes the source terminals Hc and Lc, the sensing terminals Hp and Lp, the measurement signal source 2, and a meter 3B, and is configured so as to be capable of measuring the impedance of a measurement object DUT in a state where the source terminal Hc on the Hi side and the sensing terminal Hp on the Hi side are connected to one electrode of the measurement object DUT and the source terminal Lc on the Lo side and the sensing terminal Lp on the Lo side are connected to the other electrode of the measurement object DUT. The AC signal source 21a of the test signal source 21 is connected between the sensing terminal Hp and the sensing terminal Lp in a state where the AC signal source 21a is connected in series with the coupling capacitor 21b.

The meter 3B includes a test signal source 21, a first detector 22B, a second detector 23B, a third detector 24B, a fourth detector 25B, a fifth detector 26B, a processor 27, and an outputter 28. The meter 3B measures, along with the internal resistance Rx of the measurement object DUT, the contact resistances R_{HC}, R_{LC}, R_{HP}, and R_{LP}. The meter 3B operates based on a DC voltage (a DC voltage (that is, a DC positive voltage and a DC negative voltage) that has the potential of the second ground G2 that is electrically separated from the first ground G1 as a reference), which is supplied from a power supply system, not illustrated, for the meter 3B (a separate power supply system that is electrically separated from the first power supply system described above, and also referred to hereinafter as the "second power supply system").

The first detector 22B is connected to the source terminals Hc and Lc, detects, with reference to the second ground G2, a voltage (a sinusoidal voltage signal) V_{HC1} generated between the source terminals Hc and Lc based on the AC measurement current Im, and outputs a first detection voltage Vdv1, which is a DC voltage whose voltage value changes according to the voltage value (for example, the amplitude) of the voltage V_{HC1}.

As one example, the first detector 22B includes two coupling capacitors 31a and 31b, the first amplifier 32, the first filter 33, the detection circuit 34, and the second filter 35. The first amplifier 32 is constructed of an instrumentation amplifier 32f whose non-inverting input terminal is connected via the coupling capacitor 31a to the source terminal Hc, whose inverting input terminal is connected via the coupling capacitor 31b to the source terminal Lc, and which has two input resistors 32d and 32e with the same resistance value connected in series between the non-inverting input terminal and the inverting input terminal. The connection point between the input resistors 32d and 32e is connected to the second ground G2. With this configuration, the first amplifier 32 of the first detector 22B inputs the AC voltage V_{HC} generated between the source terminals Hc and Lc (a voltage that includes the voltage V_{HC1} as a voltage component) via the coupling capacitors 31a and 31b, amplifies at a specified amplification factor, and outputs as an amplified signal. Note that in the present embodiment, the coupling capacitors 31a and 31b are provided to avoid a situation where the DC electromotive force outputted from the measurement object DUT is applied to the input terminal of the first amplifier 32. Accordingly, when the measurement object DUT does not generate a DC electromotive force, it is also possible to use a configuration where the non-inverting input terminal of the instrumentation amplifier 32f that constructs the first amplifier 32 is directly connected to the source terminal Hc and the inverting input terminal is directly connected to the source terminal Lc without the coupling capacitors 31a and 31b being provided.

The first filter 33 removes the frequency components (noise components) outside the pass band included in the amplified signal outputted from the first amplifier 32 and outputs the resulting signal. The detection circuit 34 synchronously detects the signal outputted from the first filter 33 using the synchronization signal S_{SY1}, and outputs a DC signal whose voltage value changes according to the voltage value (for example, the amplitude) of the voltage component (the voltage V_{HC1}) based on the AC measurement current Im out of the voltage components that compose the voltage V_{HC}. The second filter 35 inputs the DC signal outputted from the detection circuit 34, removes the AC component, and performs smoothing to output the first detection voltage Vdv1.

Here, since the first detection voltage Vdv1 is a voltage obtained by detecting, with reference to the second ground G2, the voltage V_{HC1} generated between the source terminals Hc and Lc based on the AC measurement current Im, the voltage value of the first detection voltage Vdv1 takes a value (∝R_{HC}+Rx+R_{LC}) that is proportional to the combined series resistance (R_{HC}+Rx+R_{LC}) of the internal resistance Rx and the contact resistances R_{HC} and R_{LC}. For this reason, the combined series resistance (R_{HC}+Rx+R_{LC}) is calculated by dividing the voltage value of the first detection voltage Vdv1 by the known current value of the AC measurement current Im.

The second detector 23B is connected to the source terminal Lc and the sensing terminal Lp, detects, with reference to the second ground G2, a voltage (a sinusoidal voltage signal) V_{L1} generated between the source terminal Lc and the sensing terminal Lp based on the AC measurement current Im, and outputs a second detection voltage Vdv2, which is a DC voltage whose voltage value changes according to the voltage value (for example, the amplitude) of the voltage V_{L1}.

As one example, the second detector 23B includes coupling capacitors 41a and 41b, the second amplifier 42, the third filter 43, the detection circuit 44, and the fourth filter 45. The second amplifier 42 is constructed of an instrumentation amplifier 42f whose non-inverting input terminal is connected via the coupling capacitor 41a to the sensing terminal Lp, whose inverting input terminal is connected via the coupling capacitor 41b to the source terminal Lc, and which has two input resistors 42d and 42e with the same resistance value connected in series between the non-inverting input terminal and the inverting input terminal. The connection point between the input resistors 42d and 42e is connected to the second ground G2. With this configuration, the second amplifier 42 of the second detector 23B inputs the AC voltage V_{L} generated between the source terminal Lc and the sensing terminal Lp (a voltage including the voltage V_{L1} and a voltage V_{L2} described later as voltage components) via the coupling capacitors 41a and 41b, amplifies at a specified amplification factor, and outputs as an amplified signal. Note that in the present embodiment, the coupling capacitors 41a and 41b are provided to avoid a situation where the DC electromotive force outputted from the measurement object DUT is applied to the input terminal of the second amplifier 42. Accordingly, when the measurement object DUT does not generate a DC electromotive force, it is also possible to use a configuration where the non-inverting input terminal of the instrumentation amplifier 42f that constructs the second amplifier 42 is directly connected to the sensing terminal Lp and the inverting input terminal is directly connected to the source terminal Lc without the coupling capacitors 41a and 41b being provided.

The third filter 43 removes frequency components (noise components) outside the pass band (a frequency band including the frequencies f1 and f2) included in the amplified signal outputted from the second amplifier 42 and outputs the resulting signal. The detection circuit 44 synchronously detects the signal outputted from the third filter 33 using the synchronous signal S_{SY1}, and outputs a DC signal whose voltage value changes according to a voltage value (for example, the amplitude) of the voltage component (voltage V_{L1}) based on the AC measurement current Im out of the voltage components that compose the voltage V_{L}. The fourth filter 45 inputs the DC signal outputted from the detection circuit 44, removes the AC component, and performs smoothing to output the second detection voltage Vdv2.

Here, since the second detection voltage Vdv2 is a voltage obtained by detecting, with reference to the second ground G2, the voltage V_{L1} generated between the source terminal Lc and the sensing terminal Lp based on the AC measurement current Im, the voltage value of the second detection voltage Vdv2 is a value (∝R_{LC}) that is proportional to the contact resistance R_{LC}. For this reason, the contact resistance R_{LC} is calculated by dividing the voltage value of the second detection voltage Vdv2 by the known current value of the AC measurement current Im.

The third detector 24B is connected to the source terminal Lc and the sensing terminal Lp, detects, with reference to the second ground G2, a voltage (a sinusoidal voltage signal) V_{L2} generated between the source terminal Lc and the sensing terminal Lp based on the AC test current Id, and outputs a third detection voltage Vdv3, which is a DC voltage whose voltage value changes according to the voltage value (for example, the amplitude) of the voltage V_{L2}.

As one example, the third detector 24B includes the coupling capacitors 41a and 41b, the second amplifier 42, the third filter 43, the detection circuit 54, and the fifth filter 55. As one example, the third detector 24B in the present embodiment uses a configuration where the coupling capacitors 41a and 41b, the second amplifier 42, and the third filter 43 are shared with the second detector 23B. However, the configuration of the third detector 24B is not limited to this, and in the same way as the impedance measuring apparatus 1A described above, can be subjected to various modifications, such as being provided with components corresponding to the coupling capacitors 41a and 41b, the second amplifier 42 and the third filter 43 that are dedicated to the third detector 24B.

In the third detector 24B, the detection circuit 54 synchronously detects the signal outputted from the third filter 33 using the synchronization signal S_{SY2} and outputs a DC signal whose voltage value changes according to the voltage value (for example, the amplitude) of the voltage component (the voltage V_{L2}) based on the AC test current Id out of the voltage components that compose the voltage V_{L}, and the fifth filter 55 inputs the DC signal outputted from the detection circuit 54, removes the AC component, and performs smoothing to output the third detection voltage Vdv3.

Here, since the third detection voltage Vdv3 is a voltage obtained by detecting, with reference to the second ground G2, the voltage V_{L2} generated between the source terminal Lc and the sensing terminal Lp based on the AC test current Id, the voltage value of the third detection voltage Vdv3 is a value (∝R_{LP}) that is proportional to the contact resistance R_{LP}. For this reason, the contact resistance R_{LP} is calculated by dividing the voltage value of the third detection voltage Vdv3 by the known current value of the AC test current Id.

The fourth detector 25B is connected to the sensing terminals Hp and Lp, detects, with reference to the second ground G2, a voltage V_{HP1} generated between the sensing terminals Hp and Lp based on the AC measurement current Im, and outputs a fourth detection voltage Vdv4, which is a DC voltage whose voltage value changes according to the voltage value (for example, the amplitude) of the voltage V_{HP1}.

As one example, the fourth detector 25B includes the coupling capacitors 61a and 61b, the third amplifier 62, the sixth filter 63, the detection circuit 64, and the seventh filter 65. The third amplifier 62 is constructed of an instrumentation amplifier 62f whose non-inverting input terminal is connected via the coupling capacitor 61a to the sensing terminal Hp, whose inverting input terminal is connected to the sensing terminal Lp via the coupling capacitor 61b, and which has two input resistors 62d and 62e with the same resistance value connected in series between the non-inverting input terminal and the inverting input terminal. The connection point between the input resistors 62d and 62e is connected to the second ground G2. With this configuration, the third amplifier 62 of the fourth detector 25B inputs the AC voltage V_{HP} (a voltage that includes the voltage V_{HP1} and a voltage V_{HP2} described later as voltage components) generated between the sensing terminals Hp and Lp via the coupling capacitors 61a and 61b, amplifies at a specified amplification factor, and outputs as an amplified signal. Note that in the present embodiment, coupling capacitors 61a and 61b are provided to avoid a situation where the DC electromotive force outputted from the measurement object DUT is applied to the input terminal of the third amplifier 62. Accordingly, when the measurement object DUT does not generate a DC electromotive force, it is also possible to use a configuration where the non-inverting input terminal of the instrumentation amplifier 62f that constructs the third amplifier 62 is directly connected to the sensing terminal Hp and the inverting input terminal is directly connected to the sensing terminal Lp without the coupling capacitors 61a and 61b being provided.

The sixth filter 63 removes frequency components (noise components) outside the pass band (a frequency band including the frequencies f1 and f2) included in the amplified signal outputted from the third amplifier 62 and outputs the resulting signal. The detection circuit 64 synchronously detects the signal outputted from the sixth filter 63 using the synchronization signal S_{SY1} and outputs a DC signal whose voltage value changes according to the voltage value of the voltage component (the voltage V_{HP1}) based on the AC measurement current Im out of the voltage components that construct the voltage V_{HP}. The seventh filter 65 inputs the DC signal outputted from the detection circuit 64, removes the AC component, and performs smoothing to output the fourth detection voltage Vdv4.

Here, since the fourth detection voltage Vdv4 is a voltage obtained by detecting, with reference to the second ground G2, the voltage V_{HP1} generated between the sensing terminals Hp and Lp based on the AC measurement current Im, the voltage value is a value (∝Rx) that is proportional to the internal resistance Rx. For this reason, the internal resistance Rx is calculated by dividing the voltage value of the fourth detection voltage Vdv4 by the known current value of the AC measurement current Im.

The fifth detector 26B is connected to the sensing terminals Hp and Lp, detects, with reference to the second ground G2, the voltage V_{HP2} generated between the sensing terminals Hp and Lp based on the AC test current Id, and outputs a fifth detection voltage Vdv5, which is a DC voltage whose voltage value changes according to the voltage value (for example, the amplitude) of the voltage V_{HP2}.

As one example, the fifth detector 26B includes the coupling capacitors 61a and 61b, the third amplifier 62, the sixth filter 63, the detection circuit 74, and the eighth filter 75. As one example, the fifth detector 26B in the present embodiment uses a configuration where the coupling capacitors 61a and 61b, the third amplifier 62, and the sixth filter 63 are shared with the fourth detector 25B. However, the configuration of the fifth detector 26B is not limited to this, and in the same way as the impedance measuring apparatus 1A described above, can be subjected to various modifications, such as being provided with components corresponding to the coupling capacitors 61a and 61b, the third amplifier 62, and the sixth filter 63 that are dedicated to the fifth detector 26B.

In the fifth detector 26B, the detection circuit 74 synchronously detects the signal outputted from the sixth filter 63 using the synchronization signal S_{SY2}, outputs a DC signal whose voltage value changes according to the voltage value (for example, the amplitude) of the voltage component (the voltage V_{HP2}) based on the AC test current Id out of the voltage components that compose the voltage V_{HP}. The eighth filter 75 inputs the DC signal outputted from the detection circuit 74, removes the AC component and performs smoothing to output a fifth detection voltage Vdv5.

Here, since the fifth detection voltage Vdv5 is a voltage obtained by detecting, with reference to the second ground G2, the voltage V_{HP2} generated between the sensing terminals Hp and Lp based on the AC test current Id, the voltage value is a value (∝R_{HP}+Rx+R_{LP}) that is proportional to the combined series resistance (R_{HP}+Rx+R_{LP}) of the contact resistance R_{HP}, the internal resistance Rx, and the contact resistance R_{LP}. For this reason, the combined series resistance (R_{HP}+Rx+R_{LP}) is calculated by dividing the voltage value of the fifth detection voltage Vdv5 by the known current value of the AC test current Id.

Next, the operation of the impedance measuring apparatus 1B will be described with reference to the drawings.

With the impedance measuring apparatus 1B, to the measurement object DUT, the measurement signal source 2 supplies an AC measurement current Im and the test signal source 21 of the meter 3B supplies the AC test current Id. In this state, in the meter 3B, the first detector 22B detects, with reference to the second ground G2, the voltage V_{HC1} included in the AC voltage V_{HC} generated between the source terminals Hc and Lc and outputs the first detection voltage Vdv1 whose voltage value changes according to the voltage value of the voltage V_{HC1}. The second detector 23B detects, with reference to the second ground G2, the voltage V_{L1} included in the AC voltage V_{L} generated between the source terminal Lc and the sensing terminal Lp and outputs the second detection voltage Vdv2 whose voltage value changes according to the voltage value of the voltage V_{L1}. The third detector 24B detects, with reference to the second ground G2, the voltage V_{L2} included in the AC voltage V_{L} generated between the source terminal Lc and the sensing terminal Lp and outputs the third detection voltage Vdv3 whose voltage value changes according to the voltage value of the voltage V_{L2}. The fourth detector 25B detects, with reference to the second ground G2, the voltage V_{HP1} included in the AC voltage V_{HP} generated between the sensing terminals Hp and Lp and outputs the fourth detection voltage Vdv4 whose voltage value changes according to the voltage value of the voltage V_{HP1}. The fifth detector 26B detects, with reference to the second ground G2, the voltage V_{HP2} included in the AC voltage V_{HP} generated between the sensing terminals Hp and Lp and outputs the fifth detection voltage Vdv5 whose voltage value changes according to the voltage value of the voltage V_{HP2}.

The processor 27 executes the impedance measuring process based on the detection voltages Vdv1, Vdv2, Vdv3, Vdv4, and Vdv5 outputted from the detectors 22B, 23B, 24B, 25B, and 26B. In this impedance measuring process, the processor 27 first performs A/D conversion on the detection voltages Vdv1, Vdv2, Vdv3, Vdv4, and Vdv5 to convert to voltage data that indicates the voltage values of the detection voltages Vdv1, Vdv2, Vdv3, Vdv4, and Vdv5. After this, the processor 27 detects the voltage values of the respective detection voltages Vdv1, Vdv2, Vdv3, Vdv4, and Vdv5 based on the voltage data for the respective detection voltages Vdv1, Vdv2, Vdv3, Vdv4, and Vdv5.

Here, as described above, the voltage value of the first detection voltage Vdv1 for the voltage V_{HC1} generated between the source terminals Hc and Lc based on the AC measurement current Im is a value that is proportional to the combined series resistance (R_{HC}+Rx+R_{LC}) of the contact resistance R_{HC}, the internal resistance Rx, and the contact resistance R_{LC}. The voltage value of the second detection voltage Vdv2 for the voltage V_{L1} generated between the source terminal Lc and the sensing terminal Lp based on the AC measurement current Im is a value that is proportional to the contact resistance R_{LC}. The voltage value of the third detection voltage Vdv3 for the voltage V_{L2} generated between the source terminal Lc and the sensing terminal Lp based on the AC test current Id is a value that is proportional to the contact resistance R_{LP}. The voltage value of the fourth detection voltage Vdv4 for the voltage V_{HP1} generated between the sensing terminals Hp and Lp based on the AC measurement current Im is a value that is proportional to the internal resistance Rx. The voltage value of the fifth detection voltage Vdv5 for the voltage V_{HP2} generated between the sensing terminals Hp and Lp based on the AC test current Id is a value that is proportional to the combined series resistance (R_{HP}+Rx+R_{LP}) of the contact resistance R_{HP}, the internal resistance Rx, and the contact resistance R_{LP}.

Next, the processor 27 calculates the combined series resistance (R_{HC}+Rx+R_{LC}) by dividing the voltage value of the first detection voltage Vdv1 by the known current value of the AC measurement current Im, calculates the contact resistance R_{LC} by dividing the voltage value of the second detection voltage Vdv2 by the known current value of the AC measurement current Im, calculates the contact resistance R_{LP} by dividing the voltage value of the third detection voltage Vdv3 by the known current value of the AC test current Id, calculates the internal resistance Rx by dividing the voltage value of the fourth detection voltage Vdv4 by the known current value of the AC measurement current Im, and calculates the combined series resistance (R_{HP}+Rx+R_{LP}) by dividing the voltage value of the fifth detection voltage Vdv5 by the known current value of the AC test current Id.

After this, the processor 27 calculates the contact resistance R_{HC} by subtracting the calculated internal resistance Rx and the contact resistance R_{Lc} from the calculated combined series resistance (R_{HC}+Rx+R_{LC}). The processor 27 also calculates the contact resistance R_{HP} by subtracting the calculated internal resistance Rx and the contact resistance R_{LP} from the calculated combined series resistance (R_{HP}+Rx+R_{LP}). By doing so, all four contact resistances R_{HC}, R_{LC}, R_{HP}, and R_{LP} are calculated. The processor 27 also stores the calculated internal resistance Rx and the calculated contact resistances R_{HC}, R_{LC}, R_{HP}, and R_{LP}.

Finally, the processor 27 executes the output process and has the outputter 28 display the calculated internal resistance Rx and the respective contact resistances R_{HC}, R_{LC}, R_{HP}, and R_{LP}. By doing so, measurement of the internal resistance Rx and the contact resistances R_{HC}, R_{LC}, R_{HP}, and R_{LP} by the impedance measuring apparatus 1B is completed.

In this way, according to the impedance measuring apparatus 1B also, the first ground G1 for the measuring signal source 2 and the second ground G2 for the meter 3B are electrically separated and by including, in addition to the fourth detector 25B for detecting (measuring) the internal resistance Rx, the test signal source 21 and the detectors 22B, 23B, 24B, and 26B for detecting (measuring) the respective contact resistances R_{HC}, R_{LC}, R_{HP}, and R_{LP}, it is possible to individually measure the contact resistances R_{HC}, R_{LC}, R_{HP}, and R_{LP} between the source terminal Hc, the source terminal Lc, the sensing terminal Hp, and the sensing terminal Lp and the corresponding electrodes of the measurement object DUT. This means that according to the impedance measuring apparatus 1B, it is possible to individually detect the contact states between the source terminal Hc, the source terminal Lc, the sensing terminal Hp, and the sensing terminal Lp and the corresponding electrodes of the measurement object DUT based on the measured individual contact resistances R_{HC}, R_{LC}, R_{HP}, and R_{LP}. Therefore, according to the impedance measuring apparatus 1B also, it is possible to check for the occurrence of broken connections for the measuring cables connecting the source terminal Hc, the source terminal Lc, the sensing terminal Hp, and the sensing terminal Lp and the corresponding electrode of the measurement object DUT, the progress of wear at the tips (contacts) of the measuring cables that come into contact with the measurement object DUT, and the like separately for each measuring cable.

Next, an impedance measuring apparatus 1C as an example of another impedance measuring apparatus according to the present invention will be described with reference to FIG. 3. Note that component elements that are the same as the impedance measuring apparatus 1B described above have been assigned the same reference numerals and duplicated description is omitted.

The impedance measuring apparatus 1C includes the source terminals Hc and Lc, the sensing terminals Hp and Lp, the measurement signal source 2, and a meter 3C, and is configured so as to be capable of measuring the impedance of a measurement object DUT in a state where the source terminal Hc on the Hi side and the sensing terminal Hp on the Hi side are connected to one electrode of the measurement object DUT and the source terminal Lc on the Lo side and the sensing terminal Lp on the Lo side are connected to the other electrode of the measurement object DUT.

The meter 3C has the same components as the meter 3B (that is, the test signal source 21, the first detector 22B, the second detector 23B, the third detector 24B, the fourth detector 25B, the fifth detector 26B, the processor 27 and the outputter 28) and the meter 3C differs to the meter 3B only by using a configuration where the second detector 23B and the third detector 24B are connected between the source terminal Hc and the sensing terminal Hp.

Since the meter 3C is configured with the second detector 23B and the third detector 24B connected in this way between the source terminal Hc and the sensing terminal Hp, the second detector 23B detects, with reference to the second ground G2, a voltage (a sinusoidal voltage signal) V_{H1} generated between the source terminal Hc and the sensing terminal Hp based on the AC measurement current Im out of the AC voltage V_{H} generated between the source terminal Hc and the sensing terminal Hp, and outputs the second detection voltage Vdv2, which is a DC voltage whose voltage value changes according to the voltage value (for example, the amplitude) of the voltage V_{H1}. The third detector 24B detects, with reference to the second ground G2, a voltage (a sinusoidal voltage signal) V_{H2} generated between the source terminal Hc and the sensing terminal Hp based on the AC test current Id out of the AC voltage V_{H}, and outputs the third detection voltage Vdv3, which is a DC voltage whose voltage value changes according to the voltage value (for example, the amplitude) of the voltage V_{H2}.

Here, since the voltage value of the second detection voltage Vdv2 is a value (∝R_{HC}) that is proportional to the contact resistance R_{HC}, the contact resistance R_{HC} is calculated by dividing the voltage value of the second detection voltage Vdv2 by the known current value of the AC measurement current Im. Also, since the voltage value of the third detection voltage Vdv3 is a value (∝R_{HP}) that is proportional to the contact resistance R_{HP}, the contact resistance R_{HP} is calculated by dividing the voltage value of the third detection voltage Vdv3 by the known current value of the AC test current Id.

The operation of the impedance measuring apparatus 1C will now be described. Note that only operations that are different from the impedance measuring apparatus 1B will be described, and description of operations that are the same is omitted.

In the impedance measuring process, the processor 27 detects the voltage values of the respective detection voltages Vdv1, Vdv2, Vdv3, Vdv4, and Vdv5 based on the detection voltages Vdv1, Vdv2, Vdv3, Vdv4, and Vdv5 outputted from the detectors 22B, 23B, 24B, 25B, and 26B.

Here, as described above, the voltage value of the first detection voltage Vdv1 for the voltage V_{HC1} generated between the source terminals Hc and Lc based on the AC measurement current Im is a value that is proportional to the combined series resistance (R_{HC}+Rx+R_{LC}) of the contact resistance R_{HC}, the internal resistance Rx, and the contact resistance R_{LC}. The voltage value of the second detection voltage Vdv2 for the voltage V_{H1} generated between the source terminal Hc and the sensing terminal Hp based on the AC measurement current Im is a value that is proportional to the contact resistance R_{HC}. The voltage value of the third detection voltage Vdv3 for the voltage V_{H2} generated between the source terminal Hc and the sensing terminal Hp based on the AC test current Id is a value that is proportional to the contact resistance R_{HP}. The voltage value of the fourth detection voltage Vdv4 for the voltage V_{HP1} generated between the sensing terminals Hp and Lp based on the AC measurement current Im is a value that is proportional to the internal resistance Rx. The voltage value of the fifth detection voltage Vdv5 for the voltage V_{HP2} generated between the sensing terminals Hp and Lp based on the AC test current Id is a value that is proportional to the combined series resistance (R_{HP}+Rx+R_{LP}) of the contact resistance R_{HP}, the internal resistance Rx, and the contact resistance R_{LP}.

Next, the processor 27 calculates the combined series resistance (R_{HC}+Rx+R_{LC}) by dividing the voltage value of the first detection voltage Vdv1 by the known current value of the AC measurement current Im, calculates the contact resistance R_{HC} by dividing the voltage value of the second detection voltage Vdv2 by the known current value of the AC measurement current Im, calculates the contact resistance R_{HP} by dividing the voltage value of the third detection voltage Vdv3 by the known current value of the AC test current Id, calculates the internal resistance Rx by dividing the voltage value of the fourth detection voltage Vdv4 by the known current value of the AC measurement current Im, and calculates the combined series resistance (R_{HP}+Rx+R_{LP}) by dividing the voltage value of the fifth detection voltage Vdv5 by the known current value of the AC test current Id.

After this, the processor 27 calculates the contact resistance R_{LC} by subtracting the calculated internal resistance Rx and the contact resistance R_{Hc} from the calculated combined series resistance (R_{HC}+Rx+R_{LC}). The processor 27 also calculates the contact resistance R_{LP} by subtracting the calculated internal resistance Rx and the contact resistance R_{HP} from the calculated combined series resistance (R_{HP}+Rx+R_{LP}). By doing so, all four contact resistances R_{HC}, R_{LC}, R_{HP}, and R_{LP} are calculated. The processor 27 also stores the calculated internal resistance Rx and the calculated contact resistances R_{HC}, R_{LC}, R_{HP}, and R_{LP}.

Finally, the processor 27 executes the output process and has the outputter 28 display the calculated internal resistance Rx and the respective contact resistances R_{HC}, R_{LC}, R_{HP}, and R_{LP}. By doing so, measurement of the internal resistance Rx and the contact resistances R_{HC}, R_{LC}, R_{HP}, and R_{LP} by the impedance measuring apparatus 1B is completed.

In this way, according to the impedance measuring apparatus 1C also, the first ground G1 for the measuring signal source 2 and the second ground G2 for the meter 3C are electrically separated and by including, in addition to the fourth detector 25B for detecting (measuring) the internal resistance Rx, the test signal source 21 and the detectors 22B, 23B, 24B, and 26B for detecting (measuring) the respective contact resistances R_{HC}, R_{LC}, R_{HP}, and R_{LP}, it is possible to individually measure the contact resistances R_{HC}, R_{LC}, R_{HP}, and R_{LP} between the source terminal Hc, the source terminal Lc, the sensing terminal Hp, and the sensing terminal Lp and the corresponding electrodes of the measurement object DUT. This means that according to the impedance measuring apparatus 1C, it is possible to individually detect the contact states between the source terminal Hc, the source terminal Lc, the sensing terminal Hp, and the sensing terminal Lp and the corresponding electrodes of the measurement object DUT based on the measured individual contact resistances R_{HC}, R_{LC}, R_{HP}, and R_{LP}. Therefore, according to the impedance measuring apparatus 1C also, it is possible to check for the occurrence of broken connections for the measuring cables connecting the source terminal Hc, the source terminal Lc, the sensing terminal Hp, and the sensing terminal Lp and the corresponding electrode of the measurement object DUT, the progress of wear at the tips (contacts) of the measuring cables that come into contact with the measurement object DUT, and the like separately for each measuring cable.

Next, an impedance measuring apparatus 1D as an example of another impedance measuring apparatus according to the present invention will be described with reference to FIG. 4. Note that component elements that are the same as the impedance measuring apparatuses 1A and 1B described above have been assigned the same reference numerals and duplicated description is omitted.

The impedance measuring apparatus 1D includes the source terminals Hc and Lc, the sensing terminals Hp and Lp, the measurement signal source 2, and a meter 3D, and is configured so as to be capable of measuring the impedance of a measurement object DUT in a state where the source terminal Hc on the Hi side and the sensing terminal Hp on the Hi side are connected to one electrode of the measurement object DUT and the source terminal Lc on the Lo side and the sensing terminal Lp on the Lo side are connected to the other electrode of the measurement object DUT.

The meter 3D includes a first test signal source 211, a second test signal source 212, a first detector 22D, a second detector 23D, a third detector 24D, a fourth detector 25D, a fifth detector 26D, a processor 27, and an outputter 28. The meter 3D measures, along with the internal resistance Rx of the measurement object DUT, the contact resistances R_{HC}, R_{LC}, R_{HP}, and R_{LP}. The meter 3D operates based on a DC voltage (a DC voltage (that is, a DC positive voltage and a DC negative voltage) that has the potential of the second ground G2 that is electrically separated from the first ground G1 as a reference), which is supplied from a power supply system, not illustrated, for the meter 3D (a separate power supply system that is electrically separated from the first power supply system described above, and also referred to hereinafter as the "second power supply system").

The first test signal source 211 includes an AC signal source 21a and a coupling capacitor 21b, and has the same configuration as the test signal source 21. The AC signal source 21a is connected between the source terminal Hc and the sensing terminal Hp in a state where the AC signal source 21a is connected in series to the coupling capacitor 21b and supplies a sinusoidal constant current of a constant (known) current value and a constant frequency f2 as a first AC test current Id1 between the source terminal Hc and the sensing terminal Hp. The AC signal source 21a also outputs the synchronization signal S_{SY2} with the frequency f2 that is synchronized with the first AC test current Id1.

The second test signal source 212 includes an AC signal source 212a and a coupling capacitor 212b. The AC signal source 212a is connected between the source terminal Lc and the sensing terminal Lp in a state where the AC signal source 212a is connected in series with the coupling capacitor 212b, and supplies a sinusoidal constant current that has a constant (known) current value and a constant frequency f3 (a frequency that differs to the frequencies f1 and f2) as a second AC test current Id2 between the source terminal Lc and the sensing terminal Lp. The AC signal source 212a also outputs a synchronization signal S_{SY3} with a frequency f3 that is synchronized with the second AC test current Id2.

The first detector 22D is connected to the source terminal Hc and the sensing terminal Hp, detects, with reference to the second ground G2, a voltage (a sinusoidal voltage signal) V_{H1} generated between the source terminal Hc and the sensing terminal Hp based on the AC measurement current Im, and outputs a first detection voltage Vdv1, which is a DC voltage whose voltage value changes according to the voltage value (for example, the amplitude) of the voltage V_{H1}.

As one example, the first detector 22D includes the coupling capacitors 41a and 41b, the second amplifier 42, the third filter 43, the detection circuit 44, and the fourth filter 45, and has the same configuration as the second detector 23B described above. Note that the coupling capacitor 41a is connected between the non-inverting input terminal of the instrumentation amplifier 42f and the source terminal Hc, and the coupling capacitor 41b is connected between the inverting input terminal of the instrumentation amplifier 42f and the sensing terminal Hp.

Here, since the first detection voltage Vdv1 outputted from the fourth filter 45 is a voltage obtained by detecting, with reference to the second ground G2, the voltage V_{H1} generated between the source terminal Hc and the sensing terminal Hp based on the AC measurement current Im, the voltage value of the first detection voltage Vdv1 takes a value (∝R_{HC}) that is proportional to the contact resistance R_{HC}. For this reason, the contact resistance R_{HC} is calculated by dividing the voltage value of the first detection voltage Vdv1 by the known current value of the AC measurement current Im.

The second detector 23D is connected to the source terminal Hc and the sensing terminal Hp, detects, with reference to the second ground G2, a voltage (a sinusoidal voltage signal) V_{H2} generated between the source terminal Hc and the sensing terminal Hp based on the first AC test current Id1, and outputs the second detection voltage Vdv2, which is a DC voltage whose voltage value changes according to the voltage value (for example, the amplitude) of the voltage V_{H2}.

As one example, the second detector 23D includes the coupling capacitors 41a and 41b, the second amplifier 42, the third filter 43, the detection circuit 54, and the fifth filter 55, and has the same configuration as the third detector 24B described above. Although the second detector 23D in the present embodiment uses an example configuration where the coupling capacitors 41a and 41b, the second amplifier 42, and the third filter 43 are shared with the first detector 22D, the second detector 23D is not limited to this configuration and in the same way as in the impedance measuring apparatus 1B described above, various modifications can be made, such as providing components corresponding to the coupling capacitors 41a and 41b, the second amplifier 42, and the third filter 43 that are dedicated to the third detector 24B.

Here, since the second detection voltage Vdv2 outputted from the fifth filter 55 is a voltage obtained by detecting, with reference to the second ground G2, the voltage V_{H2} generated between the source terminal Hc and the sensing terminal Hp based on the first AC test current Id1, the voltage value is a value (∝R_{HC}+R_{HP}) that is proportional to the combined series resistance (R_{HC}+R_{HP}) of the contact resistance R_{HC} and the contact resistance R_{HP}. For this reason, the combined series resistance (R_{HC}+R_{HP}) is calculated by dividing the voltage value of the second detection voltage Vdv2 by the known current value of the first AC test current Id1.

The third detector 24D is connected to the source terminal Lc and the sensing terminal Lp, detects, with reference to the second ground G2, a voltage (a sinusoidal voltage signal) V_{L1} generated between the source terminal Lc and the sensing terminal Lp based on the AC measurement current Im, and outputs a third detection voltage Vdv3, which is a DC voltage whose voltage value changes according to the voltage value (for example, the amplitude) of the voltage V_{L1}.

As one example, the third detector 24D includes coupling capacitors 81a and 81b, the fourth amplifier 82, the ninth filter (indicated as "ninth FL" in FIG. 4) 83, the detection circuit 84, and the tenth filter (indicated as "tenth FL" in FIG. 4) 85. The fourth amplifier 82 is constructed of an instrumentation amplifier 82f whose non-inverting input terminal is connected via the coupling capacitor 81a to the sensing terminal Lp, whose inverting input terminal is connected via the coupling capacitor 81b to the source terminal Lc, and which has two input resistors 82d and 82e with the same resistance value connected in series between the non-inverting input terminal and the inverting input terminal. The connection point between the input resistors 82d and 82e is connected to the second ground G2. With this configuration, the fourth amplifier 82 of the third detector 24D inputs the AC voltage V_{L} generated between the source terminal Lc and the sensing terminal Lp (a voltage including the voltage V_{L1} and a voltage V_{L2} described later as voltage components) via the coupling capacitors 81a and 81b, amplifies at a specified amplification factor, and outputs as an amplified signal. Note that in the present embodiment, the coupling capacitors 81a and 81b are provided to avoid a situation where the DC electromotive force outputted from the measurement object DUT is applied to the input terminal of the fourth amplifier 82. Accordingly, when the measurement object DUT does not generate a DC electromotive force, it is also possible to use a configuration where the non-inverting input terminal of the instrumentation amplifier 82f that constructs the fourth amplifier 82 is directly connected to the sensing terminal Lp and the inverting input terminal is directly connected to the source terminal Lc without the coupling capacitors 81a and 81b being provided.

The ninth filter 83 removes frequency components (noise components) outside the pass band (a frequency band including the frequencies f1 and f3) included in the amplified signal outputted from the fourth amplifier 82 and outputs the resulting signal. The detection circuit 84 synchronously detects the signal outputted from the ninth filter 83 using the synchronous signal S_{SY1}, and outputs a DC signal whose voltage value changes according to a voltage value (for example, the amplitude) of the voltage component (voltage V_{L1}) based on the AC measurement current Im out of the voltage components that compose the voltage V_{L}. The tenth filter 85 inputs the DC signal outputted from the detection circuit 84, removes the AC component, and performs smoothing to output the third detection voltage Vdv3.

Here, since the third detection voltage Vdv3 is a voltage obtained by detecting, with reference to the second ground G2, the voltage V_{L1} generated between the source terminal Lc and the sensing terminal Lp based on the AC measurement current Im, the voltage value of the third detection voltage Vdv3 is a value (∝R_{LC}) that is proportional to the contact resistance R_{LC}. For this reason, the contact resistance R_{LC} is calculated by dividing the voltage value of the third detection voltage Vdv3 by the known current value of the AC measurement current Im.

The fourth detector 25D is connected to the source terminal Lc and the sensing terminal Lp, detects, with reference to the second ground G2, a voltage (a sinusoidal voltage signal) V_{L2} generated between the source terminal Lc and the sensing terminal Lp based on the second AC test current Id2, and outputs a fourth detection voltage Vdv4, which is a DC voltage whose voltage value changes according to the voltage value (for example, the amplitude) of the voltage V_{L2}.

As one example, the fourth detector 25D includes the coupling capacitors 81a and 81b, the fourth amplifier 82, the ninth filter 83, the detection circuit 94, and the eleventh filter (indicated as "eleventh FL" in FIG. 4) 95. As one example, the fourth detector 25D in the present embodiment uses a configuration where the coupling capacitors 81a and 81b, the fourth amplifier 82, and the ninth filter 83 are shared with the third detector 24D. However, the configuration of the fourth detector 25D is not limited to this, and in the same way as the impedance measuring apparatus 1A described above, can be subjected to various modifications, such as being provided with components corresponding to the coupling capacitors 81a and 81b, the fourth amplifier 82 and the ninth filter 83 that are dedicated to the fourth detector 25D.

In the fourth detector 25D, the detection circuit 94 synchronously detects the signal outputted from the ninth filter 83 using the synchronization signal S_{SY3} and outputs a DC signal whose voltage value changes according to the voltage value (for example, the amplitude) of the voltage component (the voltage V_{L2}) based on the second AC test current Id2 out of the voltage components that compose the voltage V_{L}, and the eleventh filter 95 inputs the DC signal outputted from the detection circuit 94, removes the AC component, and performs smoothing to output the fourth detection voltage Vdv4.

Here, since the fourth detection voltage Vdv4 is a voltage obtained by detecting, with reference to the second ground G2, the voltage V_{L2} generated between the source terminal Lc and the sensing terminal Lp based on the second AC test current Id2, the voltage value of the fourth detection voltage Vdv4 is a value (∝R_{LC}+R_{LP}) that is proportional to the combined series resistance (R_{LC}+R_{LP}) of the contact resistance R_{LC} and the contact resistance R_{LP}. For this reason, the combined series resistance (R_{LC}+R_{LP}) is calculated by dividing the voltage value of the fourth detection voltage Vdv4 by the known current value of the second AC test current Id2.

The fifth detector 26D is connected to the sensing terminals Hp and Lp, detects, with reference to the second ground G2, a voltage (a sinusoidal voltage signal) V_{HP1} generated between the sensing terminals Hp and Lp based on the AC measurement current Im, and outputs a fifth detection voltage Vdv5, which is a DC voltage whose voltage value changes according to the voltage value (for example, the amplitude) of the voltage V_{HP1}.

As one example, the fifth detector 26D includes two coupling capacitors 31a and 31b, the first amplifier 32, the first filter 33, the detection circuit 34, and the second filter 35, and has the same configuration as the first detector 22B. Note that the coupling capacitor 31a is connected between the non-inverting input terminal of the instrumentation amplifier 32f and the sensing terminal Hp, and the coupling capacitor 31b is connected between the inverting input terminal of the instrumentation amplifier 32f and the sensing terminal Lp.

Here, since the fifth detection voltage Vdv5 outputted from the second filter 35 is a voltage obtained by detecting, with reference to the second ground G2, the voltage V_{HP1} generated between the sensing terminals Hp and Lp based on the AC measurement current Im, the voltage value is a value (∝Rx) that is proportional to the internal resistance Rx. For this reason, the internal resistance Rx is calculated by dividing the voltage value of the fifth detection voltage Vdv5 by the known current value of the AC measurement current Im.

Next, the operation of the impedance measuring apparatus 1D will be described with reference to the drawings.

With this impedance measuring apparatus 1D, in a state where the measurement signal source 2 supplies the AC measurement current Im to the measurement object DUT, the first test signal source 211 of the meter 3D supplies a first AC test current Id1 between the source terminal Hc and the sensing terminal Hp and the second test signal source 212 supplies a second AC test current Id2 between the source terminal Lc and the sensing terminal Lp, at the meter 3D, the first detector 22D detects, with reference to the second ground G2, the voltage V_{H1} included in the AC voltage V_{H} generated between the source terminal He and the sensing terminal Hp and outputs the first detection voltage Vdv1 whose voltage value changes according to the voltage value of the voltage V_{H1}. The second detector 23D detects, with reference to the second ground G2, the voltage V_{H2} included in the AC voltage V_{H} generated between the source terminal He and the sensing terminal Hp and outputs the second detection voltage Vdv2 whose voltage value changes according to the voltage value of the voltage V_{H2}. The third detector 24D detects, with reference to the second ground G2, the voltage V_{L1} included in the AC voltage V_{L} generated between the source terminal Lc and the sensing terminal Lp and outputs the third detection voltage Vdv3 whose voltage value changes according to the voltage value of the voltage V_{L1}. The fourth detector 25D detects, with reference to the second ground G2, the voltage V_{L2} included in the AC voltage V_{L} generated between the source terminal Lc and the sensing terminal Lp and outputs the fourth detection voltage Vdv4 whose voltage value changes according to the voltage value of the voltage V_{L2}. The fifth detector 26D detects, with reference to the second ground G2, the voltage V_{HP1} generated between the sensing terminals Hp and Lp and outputs the fifth detection voltage Vdv5 whose voltage value changes according to the voltage value of the voltage V_{HP1}.

The processor 27 executes the impedance measuring process based on the detection voltages Vdv1, Vdv2, Vdv3, Vdv4, and Vdv5 outputted from the detectors 22D, 23D, 24D, 25D, and 26D. In this impedance measuring process, the processor 27 first performs A/D conversion on the detection voltages Vdv1, Vdv2, Vdv3, Vdv4, and Vdv5 to convert to voltage data that indicates the voltage values of the detection voltages Vdv1, Vdv2, Vdv3, Vdv4, and Vdv5. After this, the processor 27 detects the voltage values of the respective detection voltages Vdv1, Vdv2, Vdv3, Vdv4, and Vdv5 based on the voltage data for the respective detection voltages Vdv1, Vdv2, Vdv3, Vdv4, and Vdv5.

In this case, as described above, the voltage value of the first detection voltage Vdv1 for the voltage V_{H1} generated between the source terminal He and the sensing terminal Hp based on the AC measurement current Im is a value that is proportional to the contact resistance R_{HC}. The voltage value of the second detection voltage Vdv2 for the voltage V_{H2} generated between the source terminal He and the sensing terminal Hp based on the first AC test current Id1 is a value that is proportional to the combined series resistance (R_{HC}+R_{HP}) of the contact resistance R_{HC} and the contact resistance R_{HP}. The voltage value of the third detection voltage Vdv3 for the voltage V_{L1} generated between the source terminal Lc and the sensing terminal Lp based on the AC measurement current Im is a value that is proportional to the contact resistance R_{LC}. The voltage value of the fourth detection voltage Vdv4 for the voltage V_{L2} generated between the source terminal Lc and the sensing terminal Lp based on the second AC test current Id2 is a value that is proportional to the combined series resistance (R_{LC}+R_{LP}) of the contact resistance R_{LC} and the contact resistance R_{LP}. The voltage value of the fifth detection voltage Vdv5 for the voltage V_{HP1} generated between the sensing terminals Hp and Lp based on the AC measurement current Im is a value that is proportional to the internal resistance Rx.

Next, the processor 27 calculates the contact resistance R_{HC} by dividing the voltage value of the first detection voltage Vdv1 by the known current value of the AC measurement current Im, calculates the combined series resistance (R_{HC}+R_{HP}) by dividing the voltage value of the second detection voltage Vdv2 by the known current value of the first AC test current Id, calculates the contact resistance R_{LC} by dividing the voltage value of the third detection voltage Vdv3 by the known current value of the AC measurement current Im, calculates the combined series resistance (R_{LC}+R_{LP}) by dividing the voltage value of the fourth detection voltage Vdv4 by the known current value of the second AC test current Id2, and calculates the internal resistance Rx by dividing the voltage value of the fifth detection voltage Vdv5 by the known current value of the AC measurement current Im.

After this, the processor 27 calculates the contact resistance R_{HP} by subtracting the calculated contact resistance R_{HC} from the calculated combined series resistance (R_{HC}+R_{HP}). The processor 27 also calculates the contact resistance R_{LP} by subtracting the calculated contact resistance R_{LC} from the calculated combined series resistance (R_{LC}+R_{LP}). By doing so, all four contact resistances R_{HC}, R_{LC}, R_{HP}, and R_{LP} are calculated. The processor 27 also stores the calculated internal resistance Rx and the calculated contact resistances R_{HC}, R_{LC}, R_{HP}, and R_{LP}.

Finally, the processor 27 executes the output process and has the outputter 28 display the calculated internal resistance Rx and the respective contact resistances R_{HC}, R_{LC}, R_{HP}, and R_{LP}. By doing so, measurement of the internal resistance Rx and the contact resistances R_{HC}, R_{LC}, R_{HP}, and R_{LP} by the impedance measuring apparatus 1D is completed.

In this way, according to the impedance measuring apparatus 1D also, the first ground G1 for the measuring signal source 2 and the second ground G2 for the meter 3D are electrically separated and by including, in addition to the fifth detector 26D for detecting (measuring) the internal resistance Rx, the test signal sources 211 and 212, and the detectors 22D, 23D, 24D, and 25D for detecting (measuring) the respective contact resistances R_{HC}, R_{LC}, R_{HP}, and R_{LP}, it is possible to individually measure the contact resistances R_{HC}, R_{LC}, R_{HP}, and R_{LP} between the source terminal He, the source terminal Lc, the sensing terminal Hp, and the sensing terminal Lp and the corresponding electrodes of the measurement object DUT. This means that according to the impedance measuring apparatus 1D, it is possible to individually detect the contact states between the source terminal He, the source terminal Lc, the sensing terminal Hp, and the sensing terminal Lp and the corresponding electrodes of the measurement object DUT based on the measured individual contact resistances R_{HC}, R_{LC}, R_{HP}, and R_{LP}. Therefore, according to the impedance measuring apparatus 1D also, it is possible to check for the occurrence of broken connections for the measuring cables connecting the source terminal He, the source terminal Lc, the sensing terminal Hp, and the sensing terminal Lp and the corresponding electrode of the measurement object DUT, the progress of wear at the tips (contacts) of the measuring cables that come into contact with the measurement object DUT, and the like separately for each measuring cable.

Note that the impedance measuring apparatuses 1A, 1B, and 1C described above are configured so that supplying of the AC measurement current Im from the measurement signal source 2 to the measurement object DUT and supplying of the AC test current Id from the test signal source 21 to the measurement object DUT are performed simultaneously, and the frequency f1 of the AC measurement current Im and the frequency f2 of the AC test current Id are set at different frequencies so that the first detector 22A (or 22B), the second detector 23A (or 23B), the third detector 24A (or 24B), the fourth detector 25A (or 25B), and the fifth detector 26A (or 26B) are capable of simultaneously outputting the corresponding detection voltages Vdv1, Vdv2, Vdv3, Vdv4, and Vdv5 (so that as a result, the measurement time can be shortened), and the impedance measuring apparatus 1D is configured so that supplying of the AC measurement current Im from the measurement signal source 2 to the measurement object DUT, supplying of the first AC test current Id1 from the first test signal source 211 to the source terminal He and the sensing terminal Hp, and supplying of the second AC test current Id2 from the second test signal source 212 to the source terminal Lc and the sensing terminal Lp are executed at the same time, and the frequency f1 of the AC measurement current Im and the frequencies f2 and f3 of the two AC test currents Id1 and Id2 are set at different frequencies so that the first detector 22D, the second detector 23D, the third detector 24D, the fourth detector 25D, and the fifth detector 26D are capable of outputting the corresponding detection voltages Vdv1, Vdv2, Vdv3, Vdv4, and Vdv5 at the same time (so that as a result, the measurement time can be reduced), the present invention is not limited to these configurations.

As one example, the impedance measuring apparatuses 1A, 1B, and 1C may use a configuration where, by shifting the output timing (that is, the acquisition timing at the processor 27) of the detection voltages Vdv1, Vdv2, and Vdv4 with respect to the output timing (that is, the acquisition timing at the processor 27) of the detection voltages Vdv3 and Vdv5, the frequency f1 of the AC measurement current Im and the frequency f2 of the AC test current Id are set at the same frequency.

In the impedance measuring apparatus 1D, since the current loops of the AC test currents Id1 and Id2 do not overlap, the frequencies f2 and f3 of the AC test currents Id1 and Id2 can be set at the same frequency. In the impedance measuring apparatus 1D, by shifting the output timing (that is, the acquisition timing at the processor 27) of the detection voltages Vdv1, Vdv3, and Vdv5 with respect to the output timing (that is, the acquisition timing at the processor 27) of the detection voltages Vdv2 and Vdv4, it is possible to set the frequency f1 of the AC measurement current Im and the frequencies f2 and f3 of the AC test currents Id1 and Id2 at the same frequency.

### Industrial Applicability

According to the present invention, it is possible to individually measure the contact resistances between the source terminals for supplying a signal on the Hi side and Lo side and the sensing terminals for detecting a signal on the Hi side and Lo side and the corresponding electrodes on a measurement object (that is, the contact states between the respective source terminals and the respective sensing terminals and the corresponding electrodes on the measurement object can be detected individually). This means that the present invention can be widely applied to a four-wire impedance measuring apparatus with a pair of source terminals and a pair of sensing terminals that are connected to a measurement object (that is, an impedance measuring apparatus that measures impedance using a four-terminal method).

### Reference Signs List

- 1A, 1B, 1C, 1D: Impedance measuring apparatus
- 2: Measurement signal source
- 3A, 3B, 3C, 3D: Meter
- 21, 211, 212: Test signal source
- 22A, 22B, 22D: First detector
- 23A, 23B, 23D: Second detector
- 24A, 24B, 24D: Third detector
- 25A, 25B, 25D: Fourth detector
- 26A, 26B, 26D: Fifth detector
- 27: Processor
- DUT: Measurement object
- G1: First ground
- G2: Second ground
- He, Lc: Source terminal
- Hp, Lp: Sensing terminal
- Id, Id1, Id2: AC test current
- Im: AC measurement current
- R_{HC}, R_{LC}, R_{HP}, R_{LP}: Contact resistance
- Rx: Internal resistance
- Vdv1: First detection voltage
- Vdv2: Second detection voltage
- Vdv3: Third detection voltage
- Vdv4: Fourth detection voltage
- Vdv5: Fifth detection voltage

## Claims

1. An impedance measuring apparatus (1A) comprising:
a measurement signal source (2) that is configured to supply an alternating current, AC, measurement current (Im) to a measurement object (DUT) having two electrodes via a source terminal (Hc) on a Hi side connected to one of said electrodes of the measurement object (DUT) and another source terminal (LC) on a Lo side connected to the other electrode; and
a meter (3A) that is configured to measure an AC voltage generated in the measurement object (DUT) by the AC measurement current (Im) via sensing terminals (Hp, Lp) for signal detection provided on the Hi side and the Lo side and to measure impedance (Rx) of the measurement object (DUT) based on the measured AC voltage and the AC measurement current (Im),
wherein a first ground (G1) in a power supply system of the measurement signal source (2) and a second ground (G2) in a power supply system of the meter (3A) are electrically separated,
and the meter (3A) includes:
a test signal source (21) that is configured to supply an AC test current (Id) to the measurement object (DUT) which is connected between the sensing terminal (Hp) on the Hi side and the sensing terminal (Lp) on the Lo side which is connected to the second ground (G2);
a first detector (22A) that is connected to the source terminal (Hc) on the Hi side, configured to detect, with reference to the second ground (G2), a voltage (VHC1) generated at the source terminal (H_{C}) on the Hi side based on the AC measurement current (Im) flowing on a path from the source terminal (Hc) on the Hi side via the source terminal (Lc) on the Lo side to the first ground (G1), and outputs as a first detection voltage (Vdv1);
a second detector (23A) that is connected to the source terminal (Lc) on the Lo side, configured to detect, with reference to the second ground (G2), a voltage (VLC1) generated at the source terminal (Lc) on the Lo side based on the AC measurement current (Im), and outputs as a second detection voltage (Vdv2);
a third detector (24A) that is connected to the source terminal (Lc) on the Lo side, configured to detect, with reference to the second ground (G2), a voltage (VLC2) generated at the source terminal (Lc) on the Lo side based on the AC test current (Id), and outputs as a third detection voltage (Vdv3);
a fourth detector (25A) that is connected to the sensing terminal (Hp) on the Hi side, configured to detect, with reference to the second ground (G2), a voltage (VHP1) generated at the sensing terminal (Hp) on the Hi side based on the AC measurement current (Im), and outputs as a fourth detection voltage (Vdv4);
a fifth detector (26A) that is connected to the sensing terminal (Hp) on the Hi side, configured to detect, with reference to the second ground (G2), a voltage (VHP2) generated at the sensing terminal (Hp) on the Hi side based on the AC test current (Id), and outputs as a fifth detection voltage (Vdv5); and
a processor (27) configured to calculate respective contact resistances (RHc, RHp) between the electrode of the measurement object (DUT) on the Hi side and each of the source terminal (Hc) and the sensing terminal (Hp) on the Hi side, and respective contact resistances (RLc, RLp) between the electrode of the measurement object (DUT) on the Lo side and each of the source terminal (Lc) and the sensing terminal (Lp) on the Lo side, and also to calculate the impedance (Rx) based on the first detection voltage (Vdv1), the second detection voltage (Vdv2), the third detection voltage (Vdv3), the fourth detection voltage (Vdv4), the fifth detection voltage (Vdv5), the AC measurement current (Im), and the AC test current (Id).

2. An impedance measuring apparatus (1B) comprising:
a measurement signal source (2) that is configured to supply an alternating current, AC, measurement current (Im) to a measurement object (DUT) having two electrodes via a source terminal (Hc) on a Hi side connected to one of said electrodes of the measurement object (DUT) and another source terminal (Lc) on a Lo side connected to the other electrode; and
a meter (3B) that is configured to measure an AC voltage generated in the measurement object (DUT) by the AC measurement current (Im) via sensing terminals (Hp, Lp) for signal detection provided on the Hi side and the Lo side and to measure impedance (Rx) of the measurement object (DUT) based on the measured AC voltage and the AC measurement current (Im),
wherein a first ground (G1) in a power supply system of the measurement signal source (2) and a second ground (G2) in a power supply system of the meter (3B) are electrically separated,
and the meter (3B) includes:
a test signal source (21) that is configured to supply an AC test current (Id) to the measurement object (DUT) which is connected between the sensing terminal (Hp) on the Hi side and the sensing terminal (Lp) on the Lo side;
a first detector (22B) that is connected to the source terminals (Hc, Lc) on the Hi side and the Lo side, configured to detect, with reference to the second ground (G2), a voltage generated (V_{HC1}) between the source terminals (Hc, Lc) on the Hi side and the Lo side based on the AC measurement current (Im), and outputs as a first detection voltage (Vdv1);
a second detector (23B) that is connected to the source terminal (Lc) on the Lo side and the sensing terminal (Lp) on the Lo side, configured to detect, with reference to the second ground (G2), a voltage (V_{L1}) generated between the source terminal (Lc) on the Lo side and the sensing terminal (Lp) on the Lo side based on the AC measurement current (Im), and outputs as a second detection voltage (Vdv2);
a third detector (24B) that is connected to the source terminal (Lc) on the Lo side and the sensing terminal (Lp) on the Lo side, configured to detect, with reference to the second ground (G2), a voltage generated (V_{L2}) between the source terminal (Lc) on the Lo side and the sensing terminal (Lp) on the Lo side based on the AC test current (Id), and outputs as a third detection voltage (Vdv3);
a fourth detector (25B) that is connected to the sensing terminals (Hp, Lp) on the Hi side and the Lo side, configured to detect, with reference to the second ground (G2), a voltage (V_{HP1}) generated between the sensing terminals (Hp, Lp) on the Hi side and the Lo side based on the AC measurement current (Im), and outputs as a fourth detection voltage (Vdv4);
a fifth detector (26B) that is connected to the sensing terminals (Hp, Lp) on the Hi side and the Lo side, configured to detect, with reference to the second ground (G2), a voltage (V_{HP2}) generated between the sensing terminals (Hp, Lp) on the Hi side and the Lo side based on the AC test current (Id), and outputs as a fifth detection voltage (Vdv5); and
a processor (27) configured to calculate respective contact resistances (RHC, RHP) between the electrode of the measurement object (DUT) on the Hi side and each of the source terminal (Hc) and the sensing terminal (Hp) on the Hi side, and respective contact resistances (RLc, RLp) between the electrode of the measurement object (DUT) on the Lo side and each of the source terminal (Lc) and the sensing terminal (Lp) on the Lo side and also to calculate the impedance (Rx) based on the first detection voltage (Vdv1), the second detection voltage (Vdv2), the third detection voltage (Vdv3), the fourth detection voltage (Vdv4), the fifth detection voltage (Vdv5), the AC measurement current (Im), and the AC test current (Id).

3. An impedance measuring apparatus (1C) comprising:
a measurement signal source (2) that is configured to supply an alternating current, AC, measurement current (Im) to a measurement object (DUT) having two electrodes via a source terminal (Hc) on a Hi side connected to one of said electrodes of the measurement object (DUT) and another source terminal (Lc) on a Lo side connected to the other electrode; and
a meter (3C) that is configured to measure an AC voltage generated in the measurement object (DUT) by the AC measurement current (Im) via sensing terminals (Hp, Lp) for signal detection provided on the Hi side and the Lo side and to measure impedance (Rx) of the measurement object (DUT) based on the measured AC voltage and the AC measurement current (Im),
wherein a first ground (G1) in a power supply system of the measurement signal source (2) and a second ground (G2) in a power supply system of the meter (3C) are electrically separated,
and the meter (3C) includes:
a test signal source (21) that is configured to supply an AC test current (Ig) to the measurement object (DUT) which is connected between the sensing terminal (Hp) on the Hi side and the sensing terminal (Lp) on the Lo side;
a first detector (22B) that is connected to the source terminals (Hc, Lc) on the Hi side and the Lo side, configured to detect, with reference to the second ground (G2), a voltage (V_{HC1}) generated between the source terminals (Hc, Lc) on the Hi side and the Lo side based on the AC measurement current (Im), and outputs as a first detection voltage (Vdv1);
a second detector (23B) that is connected to the source terminal (Hc) on the Hi side and the sensing terminal (Hp) on the Hi side, configured to detect, with reference to the second ground (G2), a voltage (V_{H1}) generated between the source terminal on the Hi side and the sensing terminal on the Hi side based on the AC measurement current, and outputs as a second detection voltage (Vdv2);
a third detector (24B) that is connected to the source terminal (Hc) on the Hi side and the sensing terminal (Hp) on the Hi side, configured to detect, with reference to the second ground (G2), a voltage (V_{H2}) generated between the source terminal (Hc) on the Hi side and the sensing terminal (Hp) on the Hi side based on the AC test current (Id), and outputs as a third detection voltage (Vdv3);
a fourth detector (25B) that is connected to the sensing terminals (Hp, Lp) on the Hi side and the Lo side, configured to detect, with reference to the second ground (G2), a voltage ( V_{HP1}) generated between the sensing terminals (Hp, Lp) on the Hi side and the Lo side based on the AC measurement current (Im), and outputs as a fourth detection voltage (Vdv4);
a fifth detector (26B) that is connected to the sensing terminals (Hp, Lp) on the Hi side and the Lo side, configured to detect, with reference to the second ground (G2), a voltage (V_{HP2}) generated between the sensing terminals (Hp, Lp) on the Hi side and the Lo side based on the AC test current (Id), and outputs as a fifth detection voltage (Vdv5); and
a processor (27) configured to calculate respective contact resistances (RHC, RHP) between the electrode of the measurement object (DUT) on the Hi side and each of the source terminal (Hc) and the sensing terminal (Hp) on the Hi side, and respective contact resistances (RLc, RLp) between the electrode of the measurement object (DUT) on the Lo side and each of the source terminal (Lc) and the sensing terminal (Lp) on the Lo side and also to calculate the impedance (Rx) based on the first detection voltage (Vdv1), the second detection voltage (Vdv2), the third detection voltage (Vdv3), the fourth detection voltage (Vdv4), the fifth detection voltage (Vdv5), the AC measurement current (Im), and the AC test current (Id).

4. An impedance measuring apparatus according to any one of claim 1 to claim 3, wherein a frequency of the AC measurement current (Im) and a frequency of the AC test current (Id) are set at respectively different values.

5. An impedance measuring apparatus (1D) comprising:
a measurement signal source (2) that is configured to supply an alternating current, AC, measurement current (Im) to a measurement object (DUT) having two electrodes via a source terminal (Hc) on a Hi side connected to one of said electrodes of the measurement object (DUT) and another source terminal (Lc) on a Lo side connected to the other electrode; and
a meter (3D) that is configured to measure an AC voltage generated in the measurement object (DUT) by the AC measurement current (Im) via sensing terminals (Hp, Lp) for signal detection provided on the Hi side and the Lo side and to measure impedance (Rx) of the measurement object (DUT) based on the measured AC voltage and the AC measurement current (Im),
wherein a first ground (G1) in a power supply system of the measurement signal source (2) and a second ground (G2) in a power supply system of the meter (3D) are electrically separated,
and the meter (3D) includes:
a first test signal source (211) that is configured to supply a first AC test current (Id1) between the source terminal (Hc) on the Hi side and the sensing terminal (Hp) on the Hi side;
a second test signal source (212) that is configured to supply a second AC test current (Id2) between the source terminal (Lc) on the Lo side and the sensing terminal (Lp) on the Lo side;
a first detector (22D) that is connected to the source terminal (Hc) on the Hi side and the sensing terminal (Hp) on the Hi side, configured to detect, with reference to the second ground (G2), a voltage (V_{H1}) generated between the source terminal (Hc) on the Hi side and the sensing terminal (Hp) on the Hi side based on the AC measurement current (Im), and outputs as a first detection voltage (Vdv1);
a second detector (23D) that is connected to the source terminal (Hc) on the Hi side and the sensing terminal (Hp) on the Hi side, configured to detect, with reference to the second ground (G2), a voltage (V_{H2}) generated between the source terminal (Hc) on the Hi side and the sensing terminal (Hp) on the Hi side based on the first AC test current (Id1), and outputs as a second detection voltage (Vdv2);
a third detector (24D) that is connected to the source terminal (Lc) on the Lo side and the sensing terminal (Lp) on the Lo side, configured to detect, with reference to the second ground (G2), a voltage (V_{L1}) generated between the source terminal (Lc) on the Lo side and the sensing terminal (Lp) on the Lo side based on the AC measurement current (Im), and outputs as a third detection voltage (Vdv3);
a fourth detector (25D) that is connected to the source terminal (Lc) on the Lo side and the sensing terminal (Lp) on the Lo side, configured to detect, with reference to the second ground (G2), a voltage (V_{L2}) generated between the source terminal (Lc) on the Lo side and the sensing terminal (Lp) on the Lo side based on the second AC test current (Id2), and outputs as a fourth detection voltage (Vdv4);
a fifth detector (26D) that is connected to the sensing terminals (Hp, Lp) on the Hi side and the Lo side, configured to detect, with reference to the second ground (G2), a voltage (V_{HP1}) generated between the sensing terminals (Hp, Lp) on the Hi side and the Lo side based on the AC measurement current (Im), and outputs as a fifth detection voltage (Vdv5); and
a processor (27) configured to calculate respective contact resistances (RHC, RHP) between the electrode of the measurement object (DUT) on the Hi side and each of the source terminal (Hc) and the sensing terminal (Hp) on the Hi side, and respective contact resistances (RLc, RLp) between the electrode of the measurement object (DUT) on the Lo side and each of the source terminal (Lc) and the sensing terminal (Lp) on the Lo side and also to calculate the impedance (Rx) based on the first detection voltage (Vdv1), the second detection voltage (Vdv2), the third detection voltage (Vdv3), the fourth detection voltage (Vdv4), the fifth detection voltage (Vdv5), the AC measurement current (Im), the first AC test current (Id1), and the second AC test current (Id2) .

6. An impedance measuring apparatus according to claim 5,
wherein a frequency of the AC measurement current (Im) is set at a different value to a frequency of the first AC test current (Id1) and a frequency of the second AC test current (Id2).

## Patentansprüche

1. Impedanzmessvorrichtung (1A), umfassend:
eine Messsignalquelle (2), die konfiguriert ist, einen Wechselstrom-Messstrom (Im) einem Messobjekt (DUT) mit zwei Elektroden über einen mit einer der Elektroden des Messobjekts (DUT) verbundenen Quellenanschluss (Hc) auf einer Hi-Seite und einen mit der anderen Elektrode verbundenen Quellenanschluss (Lc) auf einer Lo-Seite zuzuführen; und
ein Messinstrument (3A), das konfiguriert ist, eine durch den AC-Messstrom (Im) in dem Messobjekt (DUT) erzeugte AC-Spannung über auf der Hi-Seite und der Lo-Seite bereitgestellte Messanschlüsse (Hp, Lp) zur Signaldetektion zu messen und die Impedanz (Rx) des Messobjekts (DUT) basierend auf der gemessenen AC-Spannung und dem AC-Messstrom (Im) zu messen,
wobei eine erste Masse (G1) in einem Leistungsversorgungssystem der Messsignalquelle (2) und eine zweite Masse (G2) in einem Leistungsversorgungssystem des Messinstruments (3A) galvanisch getrennt sind,
und wobei das Messinstrument (3A) aufweist:
eine Prüfsignalquelle (21), die konfiguriert ist, einen AC-Prüfstrom (Id) dem Messobjekt (DUT) zuzuführen, das zwischen dem Messanschluss (Hp) auf der Hi-Seite und dem Messanschluss (Lp) auf der Lo-Seite, der mit der zweiten Masse (G2) verbunden ist, angeordnet und damit verbunden ist;
einen ersten Detektor (22A), der mit dem Quellenanschluss (Hc) auf der Hi-Seite verbunden ist und konfiguriert ist, mit Bezug auf die zweite Masse (G2) eine Spannung (VHC1) zu detektieren, die an dem Quellenanschluss (H_{c}) auf der Hi-Seite basierend auf dem AC-Messstrom (Im) erzeugt wird, der auf einem Pfad von dem Quellenanschluss (Hc) auf der Hi-Seite über den Quellenanschluss (Lc) auf der Lo-Seite zu der ersten Masse (G1) fließt, und sie als erste Detektionsspannung (Vdv1) ausgibt;
einen zweiten Detektor (23A), der mit dem Quellenanschluss (Lc) auf der Lo-Seite verbunden ist und konfiguriert ist, mit Bezug auf die zweite Masse (G2) eine Spannung (VLC1) zu detektieren, die an dem Quellenanschluss (Lc) auf der Lo-Seite basierend auf dem AC-Messstrom (Im) erzeugt wird, und sie als zweite Detektionsspannung (Vdv2) ausgibt;
einen dritten Detektor (24A), der mit dem Quellenanschluss (Lc) auf der Lo-Seite verbunden ist und konfiguriert ist, mit Bezug auf die zweite Masse (G2) eine Spannung (VLC2) zu detektieren, die an dem Quellenanschluss (Lc) auf der Lo-Seite basierend auf dem AC-Prüfstrom (Id) erzeugt wird, und sie als dritte Detektionsspannung (Vdv3) ausgibt;
einen vierten Detektor (25A), der mit dem Messanschluss (Hp) auf der Hi-Seite verbunden ist und konfiguriert ist, mit Bezug auf die zweite Masse (G2) eine Spannung (V_{HP1}) zu detektieren, die an dem Messanschluss (Hp) auf der Hi-Seite basierend auf dem AC-Messstrom (Im) erzeugt wird, und sie als vierte Detektionsspannung (Vdv4) ausgibt;
einen fünften Detektor (26A), der mit dem Messanschluss (Hp) auf der Hi-Seite verbunden ist und konfiguriert ist, mit Bezug auf die zweite Masse (G2) eine Spannung (VHP2) zu detektieren, die an dem Messanschluss (Hp) auf der Hi-Seite basierend auf dem AC-Prüfstrom (Id) erzeugt wird, und sie als fünfte Detektionsspannung (Vdv5) ausgibt; und
einen Prozessor (27), der konfiguriert ist, jeweilige Kontaktwiderstände (RHc, RHp) zwischen der Elektrode des Messobjekts (DUT) auf der Hi-Seite und jedem des Quellenanschlusses (Hc) und des Messanschlusses (Hp) auf der Hi-Seite und jeweilige Kontaktwiderstände (RLc, RLp) zwischen der Elektrode des Messobjekts (DUT) auf der Lo-Seite und jedem des Quellenanschlusses (Lc) und des Messanschlusses (Lp) auf der Lo-Seite zu berechnen und außerdem die Impedanz (Rx) basierend auf der ersten Detektionsspannung (Vdv1), der zweiten Detektionsspannung (Vdv2), der dritten Detektionsspannung (Vdv3), der vierten Detektionsspannung (Vdv4), der fünften Detektionsspannung (Vdv5), dem AC-Messstrom (Im) und dem AC-Prüfstrom (Id) zu berechnen.

2. Impedanzmessvorrichtung (1B), umfassend:
eine Messsignalquelle (2), die konfiguriert ist, einen Wechselstrom-Messstrom (Im) einem Messobjekt (DUT) mit zwei Elektroden über einen mit einer der Elektroden des Messobjekts (DUT) verbundenen Quellenanschluss (Hc) auf einer Hi-Seite und einen mit der anderen Elektrode verbundenen Quellenanschluss (Lc) auf einer Lo-Seite zuzuführen; und
ein Messinstrument (3B), das konfiguriert ist, eine durch den AC-Messstrom (Im) in dem Messobjekt (DUT) erzeugte AC-Spannung über auf der Hi-Seite und der Lo-Seite bereitgestellte Messanschlüsse (Hp, Lp) zur Signalerkennung zu messen und die Impedanz (Rx) des Messobjekts (DUT) basierend auf der gemessenen AC-Spannung und dem AC-Messstrom (Im) zu messen,
wobei eine erste Masse (G1) in einem Leistungsversorgungssystem der Messsignalquelle (2) und eine zweite Masse (G2) in einem Leistungsversorgungssystem des Messinstruments (3B) galvanisch getrennt sind,
und wobei das Messinstrument (3B) Folgendes beinhaltet:
eine Prüfsignalquelle (21), die konfiguriert ist, einen AC-Prüfstrom (Id) dem Messobjekt (DUT) zuzuführen, das zwischen dem Messanschluss (Hp) auf der Hi-Seite und dem Messanschluss (Lp) auf der Lo-Seite angeordnet und damit verbunden ist;
einen ersten Detektor (22B), der mit den Quellenanschlüssen (Hc, Lc) auf der Hi-Seite und der Lo-Seite verbunden ist und konfiguriert ist, mit Bezug auf die zweite Masse (G2) eine Spannung (V_{HC1}) zu detektieren, die zwischen den Quellenanschlüssen (Hc, Lc) auf der Hi-Seite und der Lo-Seite basierend auf dem AC-Messstrom (Im) erzeugt wird, und sie als erste Detektionsspannung (Vdv1) ausgibt;
einen zweiten Detektor (23B), der mit dem Quellenanschluss (Lc) auf der Lo-Seite und dem Messanschluss (Lp) auf der Lo-Seite verbunden ist und konfiguriert ist, mit Bezug auf die zweite Masse (G2) eine Spannung (V_{L1}) zu detektieren, die zwischen dem Quellenanschluss (Lc) auf der Lo-Seite und dem Messanschluss (Lp) auf der Lo-Seite basierend auf dem AC-Messstrom (Im) erzeugt wird, und sie als zweite Detektionsspannung (Vdv2) ausgibt;
einen dritten Detektor (24B), der mit dem Quellenanschluss (Lc) auf der Lo-Seite und dem Messanschluss (Lp) auf der Lo-Seite verbunden ist und konfiguriert ist, mit Bezug auf die zweite Masse (G2) eine Spannung (V_{L2}) zu detektieren, die zwischen dem Quellenanschluss (Lc) auf der Lo-Seite und dem Messanschluss (Lp) auf der Lo-Seite basierend auf dem AC-Prüfstrom (Id) erzeugt wird, und sie als dritte Detektionsspannung (Vdv3) ausgibt;
einen vierten Detektor (25B), der mit den Messanschlüssen (Hp, Lp) auf der Hi-Seite und der Lo-Seite verbunden ist und konfiguriert ist, mit Bezug auf die zweite Masse (G2) eine Spannung (V_{HP1}) zu detektieren, die zwischen den Messanschlüssen (Hp, Lp) auf der Hi-Seite und der Lo-Seite basierend auf dem AC-Messstrom (Im) erzeugt wird, und sie als vierte Detektionsspannung (Vdv4) ausgibt;
einen fünften Detektor (26B), der mit den Messanschlüssen (Hp, Lp) auf der Hi-Seite und der Lo-Seite verbunden ist und konfiguriert ist, mit Bezug auf die zweite Masse (G2) eine Spannung (V_{HP2}) zu detektieren, die zwischen den Messanschlüssen (Hp, Lp) auf der Hi-Seite und der Lo-Seite basierend auf dem AC-Prüfstrom (Id) erzeugt wird, und sie als fünfte Detektionsspannung (Vdv5) ausgibt; und
einen Prozessor (27), der konfiguriert ist, jeweilige Kontaktwiderstände (RHC, RHP) zwischen der Elektrode des Messobjekts (DUT) auf der Hi-Seite und jedem des Quellenanschlusses (Hc) und des Messanschlusses (Hp) auf der Hi-Seite und jeweilige Kontaktwiderstände (RLc, RLp) zwischen der Elektrode des Messobjekts (DUT) auf der Lo-Seite und jedem des Quellenanschlusses (Lc) und des Messanschlusses (Lp) auf der Lo-Seite zu berechnen und außerdem die Impedanz (Rx) basierend auf der ersten Detektionsspannung (Vdv1), der zweiten Detektionsspannung (Vdv2), der dritten Detektionsspannung (Vdv3), der vierten Detektionsspannung (Vdv4), der fünften Detektionsspannung (Vdv5), dem AC-Messstrom (Im) und dem AC-Prüfstrom (Id) zu berechnen.

3. Impedanzmessvorrichtung (1C), umfassend:
eine Messsignalquelle (2), die konfiguriert ist, einen Wechselstrom-Messstrom (Im) einem Messobjekt (DUT) mit zwei Elektroden über einen mit einer der Elektroden des Messobjekts (DUT) verbundenen Quellenanschluss (Hc) auf einer Hi-Seite und einen mit der anderen Elektrode verbundenen Quellenanschluss (Lc) auf einer Lo-Seite zuzuführen; und
ein Messinstrument (3C), das konfiguriert ist, eine durch den AC-Messstrom (Im) in dem Messobjekt (DUT) erzeugte AC-Spannung über auf der Hi-Seite und der Lo-Seite bereitgestellte Messanschlüsse (Hp, Lp) zur Signalerkennung zu messen und die Impedanz (Rx) des Messobjekts (DUT) basierend auf der gemessenen AC-Spannung und dem AC-Messstrom (Im) zu messen,
wobei eine erste Masse (G1) in einem Leistungsversorgungssystem der Messsignalquelle (2) und eine zweite Masse (G2) in einem Leistungsversorgungssystem des Messinstruments (3C) galvanisch getrennt sind,
und wobei das Messinstrument (3C) Folgendes beinhaltet:
eine Prüfsignalquelle (21), die konfiguriert ist, einen AC-Prüfstrom (Ig) dem Messobjekt (DUT) zuzuführen, das zwischen dem Messanschluss (Hp) auf der Hi-Seite und dem Messanschluss (Lp) auf der Lo-Seite angeordnet und damit verbunden ist;
einen ersten Detektor (22B), der mit den Quellenanschlüssen (Hc, Lc) auf der Hi-Seite und der Lo-Seite verbunden ist und konfiguriert ist, mit Bezug auf die zweite Masse (G2) eine Spannung (V_{HC1}) zu detektieren, die zwischen den Quellenanschlüssen (Hc, Lc) auf der Hi-Seite und der Lo-Seite basierend auf dem AC-Messstrom (Im) erzeugt wird, und sie als erste Detektionsspannung (Vdv1) ausgibt;
einen zweiten Detektor (23B), der mit dem Quellenanschluss (Hc) auf der Hi-Seite und dem Messanschluss (Hp) auf der Hi-Seite verbunden ist und konfiguriert ist, mit Bezug auf die zweite Masse (G2) eine Spannung (V_{H1}) zu detektieren, die zwischen dem Quellenanschluss auf der Hi-Seite dem Messanschluss auf der Hi-Seite basierend auf dem AC-Messstrom erzeugt wird, und sie als zweite Detektionsspannung (Vdv2) ausgibt;
einen dritten Detektor (24B), der mit dem Quellenanschluss (Hc) auf der Hi-Seite und dem Messanschluss (Hp) auf der Hi-Seite verbunden ist und konfiguriert ist, mit Bezug auf die zweite Masse (G2) eine Spannung (V_{H2}) zu detektieren, die zwischen dem Quellenanschluss (Hc) auf der Hi-Seite dem Messanschluss (Hp) auf der Hi-Seite basierend auf dem AC-Prüfstrom (Id) erzeugt wird, und sie als dritte Detektionsspannung (Vdv3) ausgibt;
einen vierten Detektor (25B), der mit den Messanschlüssen (Hp, Lp) auf der Hi-Seite und der Lo-Seite verbunden ist und konfiguriert ist, mit Bezug auf die zweite Masse (G2) eine Spannung (V_{HP1}) zu detektieren, die zwischen den Messanschlüssen (Hp, Lp) auf der Hi-Seite und der Lo-Seite basierend auf dem AC-Messstrom (Im) erzeugt wird, und sie als vierte Detektionsspannung (Vdv4) ausgibt;
einen fünften Detektor (26B), der mit den Messanschlüssen (Hp, Lp) auf der Hi-Seite und der Lo-Seite verbunden ist und konfiguriert ist, mit Bezug auf die zweite Masse (G2) eine Spannung (V_{HP2}) zu detektieren, die zwischen den Messanschlüssen (Hp, Lp) auf der Hi-Seite und der Lo-Seite basierend auf dem AC-Prüfstrom (Id) erzeugt wird, und sie als fünfte Detektionsspannung (Vdv5) ausgibt; und
einen Prozessor (27), der konfiguriert ist, jeweilige Kontaktwiderstände (RHC, RHP) zwischen der Elektrode des Messobjekts (DUT) auf der Hi-Seite und jedem des Quellenanschlusses (Hc) und des Messanschlusses (Hp) auf der Hi-Seite und jeweilige Kontaktwiderstände (RLc, RLp) zwischen der Elektrode des Messobjekts (DUT) auf der Lo-Seite und jedem des Quellenanschlusses (Lc) und des Messanschlusses (Lp) auf der Lo-Seite zu berechnen und außerdem die Impedanz (Rx) basierend auf der ersten Detektionsspannung (Vdv1), der zweiten Detektionsspannung (Vdv2), der dritten Detektionsspannung (Vdv3), der vierten Detektionsspannung (Vdv4), der fünften Detektionsspannung (Vdv5), dem AC-Messstrom (Im) und dem AC-Prüfstrom (Id) zu berechnen.

4. Impedanzmessvorrichtung nach einem von Anspruch 1 bis Anspruch 3, wobei eine Frequenz des AC-Messstroms (Im) und eine Frequenz des AC-Prüfstroms (Id) auf voneinander verschiedene Werte eingestellt sind.

5. Impedanzmessvorrichtung (1D), umfassend:
eine Messsignalquelle (2), die konfiguriert ist, einen Wechselstrom-Messstrom (Im) einem Messobjekt (DUT) mit zwei Elektroden über einen mit einer der Elektroden des Messobjekts (DUT) verbundenen Quellenanschluss (Hc) auf einer Hi-Seite und einen mit der anderen Elektrode verbundenen Quellenanschluss (Lc) auf einer Lo-Seite zuzuführen; und
ein Messinstrument (3D), das konfiguriert ist, eine durch den AC-Messstrom (Im) in dem Messobjekt (DUT) erzeugte AC-Spannung über auf der Hi-Seite und der Lo-Seite bereitgestellte Messanschlüsse (Hp, Lp) zur Signalerkennung zu messen und die Impedanz (Rx) des Messobjekts (DUT) basierend auf der gemessenen AC-Spannung und dem AC-Messstrom (Im) zu messen,
wobei eine erste Masse (G1) in einem Leistungsversorgungssystem der Messsignalquelle (2) und eine zweite Masse (G2) in einem Leistungsversorgungssystem des Messinstruments (3D) galvanisch getrennt sind,
und wobei das Messinstrument (3D) Folgendes beinhaltet:
eine erste Prüfsignalquelle (211), die konfiguriert ist, einen ersten AC-Prüfstrom (Id1) zwischen dem Quellenanschluss (Hc) auf der Hi-Seite und dem Messanschluss (Hp) auf der Hi-Seite zuzuführen;
eine zweite Prüfsignalquelle (212), die konfiguriert ist, einen zweiten AC-Prüfstrom (Id2) zwischen dem Quellenanschluss (Lc) auf der Lo-Seite und dem Messanschluss (Lp) auf der Lo-Seite zuzuführen;
einen ersten Detektor (22D), der mit dem Quellenanschluss (Hc) auf der Hi-Seite und dem Messanschluss (Hp) auf der Hi-Seite verbunden ist und konfiguriert ist, mit Bezug auf die zweite Masse (G2) eine Spannung (V_{H1}) zu detektieren, die zwischen dem Quellenanschluss (Hc) auf der Hi-Seite dem Messanschluss (Hp) auf der Hi-Seite basierend auf dem AC-Messstrom (Im) erzeugt wird, und sie als erste Detektionsspannung (Vdv1) ausgibt;
einen zweiten Detektor (23D), der mit dem Quellenanschluss (Hc) auf der Hi-Seite und dem Messanschluss (Hp) auf der Hi-Seite verbunden ist und konfiguriert ist, mit Bezug auf die zweite Masse (G2) eine Spannung (V_{H2}) zu detektieren, die zwischen dem Quellenanschluss (Hc) auf der Hi-Seite und dem Messanschluss (Hp) auf der Hi-Seite basierend auf dem ersten AC-Prüfstrom (Id1) erzeugt wird, und sie als zweite Detektionsspannung (Vdv2) ausgibt;
einen dritten Detektor (24D), der mit dem Quellenanschluss (Lc) auf der Lo-Seite und dem Messanschluss (Lp) auf der Lo-Seite verbunden ist und konfiguriert ist, mit Bezug auf die zweite Masse (G2) eine Spannung (V_{L1}) zu detektieren, die zwischen dem Quellenanschluss (Lc) auf der Lo-Seite und dem Messanschluss (Lp) auf der Lo-Seite basierend auf dem AC-Messstrom (Im) erzeugt wird, und sie als dritte Detektionsspannung (Vdv3) ausgibt;
einen vierten Detektor (25D), der mit dem Quellenanschluss (Lc) auf der Lo-Seite und dem Messanschluss (Lp) auf der Lo-Seite verbunden ist und konfiguriert ist, mit Bezug auf die zweite Masse (G2) eine Spannung (V_{L2}) zu detektieren, die zwischen dem Quellenanschluss (Lc) auf der Lo-Seite und dem Messanschluss (Lp) auf der Lo-Seite basierend auf dem zweiten AC-Prüfstrom (Id2) erzeugt wird, und sie als vierte Detektionsspannung (Vdv4) ausgibt;
einen fünften Detektor (26D), der mit den Messanschlüssen (Hp, Lp) auf der Hi-Seite und der Lo-Seite verbunden ist und konfiguriert ist, mit Bezug auf die zweite Masse (G2) eine Spannung (V_{HP1}) zu detektieren, die zwischen den Messanschlüssen (Hp, Lp) auf der Hi-Seite und der Lo-Seite basierend auf dem AC-Messstrom (Im) erzeugt wird, und sie als fünfte Detektionsspannung (Vdv5) ausgibt; und
einen Prozessor (27), der konfiguriert ist, jeweilige Kontaktwiderstände (RHC, RHP) zwischen der Elektrode des Messobjekts (DUT) auf der Hi-Seite und jedem des Quellenanschlusses (Hc) und des Messanschlusses (Hp) auf der Hi-Seite und jeweilige Kontaktwiderstände (RLc, RLp) zwischen der Elektrode des Messobjekts (DUT) auf der Lo-Seite und jedem des Quellenanschlusses (Lc) und des Messanschlusses (Lp) auf der Lo-Seite zu berechnen und außerdem die Impedanz (Rx) basierend auf der ersten Detektionsspannung (Vdv1), der zweiten Detektionsspannung (Vdv2), der dritten Detektionsspannung (Vdv3), der vierten Detektionsspannung (Vdv4), der fünften Detektionsspannung (Vdv5), dem AC-Messstrom (Im), dem ersten AC-Prüfstrom (Id1) und dem zweiten AC-Prüfstrom (Id2) zu berechnen.

6. Impedanzmessvorrichtung nach Anspruch 5,
wobei eine Frequenz des AC-Messstroms (Im) auf einen von einer Frequenz des ersten AC-Prüfstroms (Id1) und einer Frequenz des zweiten AC-Prüfstroms (Id2) verschiedenen Wert eingestellt ist.

## Revendications

1. Appareil de mesure de l'impédance (1A), comprenant :
une source de signal de mesure (2), qui est configurée pour fournir un courant de mesure de courant alternatif (Im) à un objet de mesure (DUT) présentant deux électrodes par l'intermédiaire d'une borne de source (Hc) sur un côté Hi connecté à l'une desdites électrodes de l'objet de mesure (DUT) et d'une autre borne de source (LC) sur un côté Lo connecté à l'autre électrode ; et
un compteur (3A), qui est configuré pour mesurer une tension alternative générée dans l'objet de mesure (DUT) par le courant de mesure de courant alternatif (Im) par l'intermédiaire de bornes de détection (Hp, Lp) pour la détection de signal fournies sur le côté Hi et le côté Lo et pour mesurer l'impédance (Rx) de l'objet de mesure (DUT) sur la base de la tension alternative mesurée et du courant de mesure de courant alternatif (Im),
dans lequel une première masse (G1) dans un système d'alimentation électrique de la source de signal de mesure (2) et une deuxième masse (G2) dans un système d'alimentation électrique du compteur (3A) sont séparées électriquement,
et le compteur (3A) comporte :
une source de signal de test (21), qui est configurée pour fournir un courant de test de courant alternatif (Id) à l'objet de mesure (DUT) qui est connecté entre la borne de détection (Hp) sur le côté Hi et la borne de détection (Lp) sur le côté Lo qui est connecté à la deuxième masse (G2) ;
un premier détecteur (22A), qui est connecté à la borne de source (Hc) sur le côté Hi, est configuré pour détecter, en référence à la deuxième masse (G2), une tension (VHC1) générée sur la borne de source (Hc) sur le côté Hi sur la base du courant de mesure de courant alternatif (Im) circulant sur un trajet depuis la borne de source (Hc) sur le côté Hi par l'intermédiaire de la borne de source (Lc) sur le côté Lo à la première masse (G1), et délivre en sortie en tant que première tension de détection (Vdv1) ;
un deuxième détecteur (23A), qui est connecté à la borne de source (Lc) sur le côté Lo, est configuré pour détecter, en référence à la deuxième masse (G2), une tension (VLC1) générée sur la borne de source (Lc) sur le côté Lo sur la base du courant de mesure de courant alternatif (Im), et délivre en sortie en tant que deuxième tension de détection (Vdv2) ;
un troisième détecteur (24A), qui est connecté à la borne de source (Lc) sur le côté Lo, est configuré pour détecter, en référence à la deuxième masse (G2), une tension (VLC2) générée sur la borne de source (Lc) sur le côté Lo sur la base du courant de test de courant alternatif (Id), et délivre en sortie en tant que troisième tension de détection (Vdv3) ;
un quatrième détecteur (25A), qui est connecté à la borne de détection (Hp) sur le côté Hi, est configuré pour détecter, en référence à la deuxième masse (G2), une tension (VHP1) générée sur la borne de détection (Hp) sur le côté Hi sur la base du courant de mesure de courant alternatif (Im), et délivre en sortie en tant qu'une quatrième tension de détection (Vdv4) ;
un cinquième détecteur (26A), qui est connecté à la borne de détection (Hp) sur le côté Hi, est configuré pour détecter, en référence à la deuxième masse (G2), une tension (VHP2) générée sur la borne de détection (Hp) sur le côté Hi sur la base du courant de test de courant alternatif (Id), et délivre en sortie en tant qu'une cinquième tension de détection (Vdv5) ; et
un processeur (27) configuré pour calculer des résistances de contact (RHc, RHp) respectives entre l'électrode de l'objet de mesure (DUT) sur le côté Hi et chacune de la borne de source (Hc) et de la borne de détection (Hp) sur le côté Hi, et des résistances de contact (RLc, RLp) respectives entre l'électrode de l'objet de mesure (DUT) sur le côté Lo et chacune de la borne de source (Lc) et de la borne de détection (Lp) sur le côté Lo, et donc pour calculer également l'impédance (Rx) sur la base de la première tension de détection (Vdv1), de la deuxième tension de détection (Vdv2), de la troisième tension de détection (Vdv3), de la quatrième tension de détection (Vdv4), de la cinquième tension de détection (Vdv5), du courant de mesure de courant alternatif (Im) et du courant de test alternatif (Id).

2. Appareil de mesure de l'impédance (1B) comprenant :
une source de signal de mesure (2), qui est configurée pour fournir un courant de mesure de courant alternatif (Im) à un objet de mesure (DUT) présentant deux électrodes par l'intermédiaire d'une borne de source (Hc) sur un côté Hi connectée à l'une desdites électrodes de l'objet de mesure (DUT) et d'une autre borne de source (Lc) sur un côté Lo connectée à l'autre électrode ; et
un compteur (3B), qui est configuré pour mesurer une tension alternative générée dans l'objet de mesure (DUT) par le courant de mesure de courant alternatif (Im) par l'intermédiaire de bornes de détection (Hp, Lp) pour la détection de signal fournies sur le côté Hi et le côté Lo et pour mesurer l'impédance (Rx) de l'objet de mesure (DUT) sur la base de la tension alternative mesurée et du courant de mesure de courant alternatif (Im),
dans lequel une première masse (G1) dans un système d'alimentation électrique de la source de signal de mesure (2) et une deuxième masse (G2) dans un système d'alimentation électrique du compteur (3B) sont séparées électriquement,
et le compteur (3B) comporte :
une source de signal de test (21), qui est configurée pour fournir un courant de test de courant alternatif (Id) à l'objet de mesure (DUT) qui est connecté entre la borne de détection (Hp) sur le côté Hi et la borne de détection (Lp) sur le côté Lo ;
un premier détecteur (22B), qui est connecté aux bornes de source (Hc, Lc) sur le côté Hi et le côté Lo, est configuré pour détecter, en référence à la deuxième masse (G2), une tension (V_{HC1}) générée entre les bornes de source (Hc, Lc) sur le côté Hi et le côté Lo sur la base du courant de mesure de courant alternatif (Im), et délivre en sortie en tant qu'une première tension de détection (Vdv1) ;
un deuxième détecteur (23B), qui est connecté à la borne de source (Lc) sur le côté Lo et à la borne de détection (Lp) sur le côté Lo, est configuré pour détecter, en référence à la deuxième masse (G2), une tension (V_{L1}) générée entre la borne de source (Lc) sur le côté Lo et la borne de détection (Lp) sur le côté Lo sur la base du courant de mesure de courant alternatif (Im), et délivre en sortie en tant qu'une deuxième tension de détection (Vdv2) ;
un troisième détecteur (24B), qui est connecté à la borne de source (Lc) sur le côté Lo et à la borne de détection (Lp) sur le côté Lo, est configuré pour détecter, en référence à la deuxième masse (G2), une tension (V_{L2}) générée entre la borne de source (Lc) sur le côté Lo et la borne de détection (Lp) sur le côté Lo sur la base du courant de test de courant alternatif (Id), et délivre en sortie en tant qu'une troisième tension de détection (Vdv3) ;
un quatrième détecteur (25B), qui est connecté aux bornes de détection (Hp, Lp), sur le côté Hi et le côté Lo, est configuré pour détecter, en référence à la deuxième masse (G2), une tension (V_{HP1}) générée entre les bornes de détection (Hp, Lp) sur le côté Hi et le côté Lo sur la base du courant de mesure de courant alternatif (Im), et délivre en sortie en tant qu'une quatrième tension de détection (Vdv4) ;
un cinquième détecteur (26B), qui est connecté aux bornes de détection (Hp, Lp) sur le côté Hi et le côté Lo, est configuré pour détecter, en référence à la deuxième masse (G2), une tension (V_{HP2}) générée entre les bornes de détection (Hp, Lp) sur le côté Hi et le côté Lo sur la base du courant de test de courant alternatif (Id), et délivre en sortie en tant qu'une cinquième tension de détection (Vdv5) ; et
un processeur (27) configuré pour calculer des résistances de contact (RHC, RHP) respectives entre l'électrode de l'objet de mesure (DUT) et chacune de la borne de source (Hc) et la borne de détection (Hp) sur le côté Hi, et des résistances de contact (RLc, RLp) respectives entre l'électrode de l'objet de mesure (DUT) sur le côté Lo et chacune de la borne de source (Lc) et de la borne de détection (Lp) sur le côté Lo, et pour calculer également l'impédance (Rx) sur la base de la première tension de détection (Vdv1), de la deuxième tension de détection (Vdv2), de la troisième tension de détection (Vdv3), de la quatrième tension de détection (Vdv4), de la cinquième tension de détection (Vdv5), du courant de mesure de courant alternatif (Im), et du courant de test de courant alternatif (Id).

3. Appareil de mesure de l'impédance (1C) comprenant :
une source de signal de mesure (2), qui est configurée pour fournir un courant de mesure de courant alternatif (Im) à un objet de mesure (DUT) présentant deux électrodes par l'intermédiaire d'une borne de source (Hc) sur un côté Hi connecté à l'une desdites électrodes de l'objet de mesure (DUT) et d'une autre borne de source (Lc) sur un côté Lo connecté à l'autre électrode ; et
un compteur (3C), qui est configuré pour mesurer une tension alternative générée dans l'objet de mesure (DUT) par le courant de mesure de courant alternatif (Im) par l'intermédiaire de bornes de détection (Hp, Lp) pour la détection de signal fournies sur le côté Hi et le côté Lo et pour mesurer l'impédance (Rx) de l'objet de mesure (DUT) sur la base de la tension alternative mesurée et du courant de mesure de courant alternatif (Im),
dans lequel une première masse (G1) dans un système d'alimentation électrique de la source de signal de mesure (2) et une deuxième masse (G2) dans un système d'alimentation électrique du compteur (3C) sont séparées électriquement,
et le compteur (3C) comporte :
une source de signal de test (21), qui est configurée pour fournir un courant de test de courant alternatif (Ig) à l'objet de mesure (DUT) qui est connecté entre la borne de détection (Hp) sur le côté Hi et à la borne de détection (Lp) sur le côté Lo ;
un premier détecteur (22B), qui est connecté aux bornes de source (Hc, Lc) sur le côté Hi et le côté Lo, est configuré pour détecter, en référence à la deuxième masse (G2), une tension (V_{HC1})générée entre les bornes de source (Hc, Lc) sur le côté Hi et le côté Lo sur la base du courant de mesure de courant alternatif (Im), et délivre en sortie en tant qu'une première tension de détection (Vdv1) ;
un deuxième détecteur (22B), qui est connecté à la borne de source (Hc) sur le côté Hi et à la borne de détection (Hp) sur le côté Hi, est configuré pour détecter, en référence à la deuxième masse (G2), une tension (V_{H1}) générée entre la borne de source sur le côté Hi et la borne de détection sur le côté Hi sur la base du courant de mesure de courant alternatif, et délivre en sortie en tant qu'une deuxième tension de détection (Vdv2) ;
un troisième détecteur (24B), qui est connecté à la borne de source (Hc) sur le côté Hi et à la borne de détection (Hp) sur le côté Hi, est configuré pour détecter, en référence à la deuxième masse (G2), une tension (V_{H2}) générée entre la borne de source (Hc) sur le côté Hi et la borne de détection (Hp) sur le côté Hi sur la base du courant de test de courant alternatif (Id), et délivre en sortie en tant qu'une troisième tension de détection (Vdv3) ;
un quatrième détecteur (25B), qui est connecté aux bornes de détection (Hp, Lp) sur le côté Hi et le côté Lo, est configuré pour détecter, en référence à la deuxième masse (G2), une tension (V_{HP1}) générée entre les bornes de détection (Hp, Lp) sur le côté Hi et le côté Lo sur la base du courant de mesure de courant alternatif (Im), et délivre en sortie en tant qu'une quatrième tension de détection (Vdv4) ;
un cinquième détecteur (26B), qui est connecté aux bornes de détection (Hp, Lp) sur le côté Hi et le côté Lo, est configuré pour détecter, en référence à la deuxième masse (G2), une tension (V_{HP2}) générée entre les bornes de détection (Hp, Lp) sur le côté Hi et le côté Lo sur la base du courant de test de courant alternatif (Id), et délivre en sortie en tant qu'une cinquième tension de détection (Vdv5) ; et
un processeur (27) configuré pour calculer des résistances de contact (RHC, RHP) respectives entre les électrodes de l'objet de mesure (DUT) sur le côté Hi et chacune de la borne de source (Hc) et de la borne de détection (Hp) sur le côté Hi, des résistances de contact (RLc, RLp) respectives entre l'électrode de l'objet de mesure (DUT) sur le côté Lo et chacune de la borne de source (Lc) et de la borne de détection (Lp) sur le côté Lo, et pour calculer également l'impédance (Rx) sur la base de la première tension de détection (Vdv1), de la deuxième tension de détection (Vdv2), de la troisième tension de détection (Vdv3), de la quatrième tension de détection (Vdv4), de la cinquième tension de détection (Vdv5), du courant de mesure de courant alternatif (Im), et du courant de test de courant alternatif (Id).

4. Appareil de mesure de l'impédance selon l'une quelconque des revendications 1 à 3, dans lequel une fréquence du courant de mesure de courant alternatif (Im) et une fréquence du courant de test de courant alternatif (Id) sont réglées sur des valeurs respectivement différentes.

5. Appareil de mesure de l'impédance (1D) comprenant :
une source de signal de mesure (2), qui est configurée pour fournir un courant de mesure de courant alternatif (Im) à un objet de mesure (DUT) présentant deux électrodes par l'intermédiaire d'une borne de source (Hc) sur le côté Hi connecté à l'une desdites électrodes d l'objet de mesure (DUT) et d'une autre borne de source (Lc) sur un côté Lo connecté à l'autre électrode ; et
un compteur (3D), qui est configuré pour mesurer une tension alternative générée dans l'objet de mesure (DUT) par le courant de mesure de courant alternatif (Im) par l'intermédiaire de bornes de détection (Hp, Lp) pour la détection de signal fournies sur le côté Hi et le côté Lo et pour mesurer l'impédance (Rx) de l'objet de mesure (DUT) sur la base de la tension alternative mesurée et du courant de mesure de courant alternatif (Im),
dans lequel une première masse (G1) dans un système d'alimentation électrique de la source de signal de mesure (2) et une deuxième masse (G2) dans un système d'alimentation électrique du compteur (3D) sont séparées électriquement,
et le compteur (3D) comporte :
une première source de signal de test (211), qui est configurée pour fournir un premier courant de test de courant alternatif (Id1) entre la borne de source (Hc) sur le côté Hi et la borne de détection (Hp) sur le côté Hi ;
une deuxième source de signal de test (212), qui est configurée pour fournir un deuxième courant de teste de courant alternatif (Id2) entre la borne de source (Lc) sur le côté Lo et la borne de détection (Lp) sur le côté Lo ;
un premier détecteur (22D), qui est connecté à la borne de source (Hc) sur le côté Hi et à la borne de détection (Hp) sur le côté Hi, est configuré pour détecter, en référence à la deuxième masse (G2), une tension (V_{H1}) générée entre la borne de source (Hc) sur le côté Hi et la borne de détection (Hp) sur le côté Hi sur la base du courant de mesure de courant alternatif (Im), et délivre en sortie en tant qu'une première tension de détection (Vdv1) ;
un deuxième détecteur (23D), qui est connecté à la borne de source (Hc) sur le côté Hi et à la borne de détection (Hp) sur le côté Hi, est configuré pour détecter, en référence à la deuxième masse (G2), une tension (V_{H2}) générée entre la borne de source (Hc) sur le côté Hi et la borne de détection (Hp) sur le côté Hi sur la base du premier courant de test de courant alternatif (Id1), et délivre en sortie en tant qu'une deuxième tension de détection (Vdv2) ;
un troisième détecteur (24D), qui est connecté à la borne de source (Lc) sur le côté Lo et à la borne de détection (Lp) sur le côté Lo, est configuré pour détecter, en référence à la deuxième masse (G2), une tension (V_{L1}) générée entre la borne de source (Lc) sur le côté Lo et la borne de détection (Lp) sur le côté Lo sur la base du courant de mesure de courant alternatif (Im), et délivre en sortie en tant qu'une troisième tension de détection (Vdv3) ;
un quatrième détecteur (25D), qui est connecté à la borne de source (Lc) sur le côté Lo et à la borne de détection (Lp) sur le côté Lo, est configuré pour détecter, en référence à la deuxième masse (G2), une tension (V_{L2}) générée entre la borne de source (Lc) sur le côté Lo et la borne de détection (Lp) sur le côté Lo sur la base du deuxième courant de test de courant alternatif (Id2), et délivre en sortie en tant qu'une quatrième tension de détection (Vdv4) ;
un cinquième détecteur (26D), qui est connecté aux bornes de détection (Hp, Lp) sur le côté Hi et le côté Lo, est configuré pour détecter, en référence à la deuxième masse (G2), une tension (V_{HP1}) générée entre les bornes de détection (Hp, Lp) sur le côté Hi et le côté Lo sur la base du courant de mesure de courant alternatif (Im), et délivre en sortie en tant qu'une cinquième tension de détection (Vdv5) ; et
un processeur (27) configuré pour calculer des résistances de contact (RHC, RHP) respectives entre l'électrode de l'objet de mesure (DUT) sur le côté Hi et chacune de la borne de source (Hc) et la borne de détection (Hp) sur le côté Hi, et des résistances de contact (RLc, RLp) respectives entre l'électrode de l'objet de mesure (DUT) sur le côté Lo et chacune de la borne de source (Lc) et de la borne de détection (Lp) sur le côté Lo et pour calculer également l'impédance (Rx) sur la base de la première tension de détection (Vdv1), de la deuxième tension de détection (Vdv2), de la troisième tension de détection (Vdv3), de la quatrième tension de détection (Vdv4), de la cinquième tension de détection (Vdv5), du courant de mesure de courant alternatif (Im), du premier courant de test de courant alternatif (Id1), et du deuxième courant de test de courant alternatif (Id2).

6. Appareil de mesure de l'impédance selon la revendication 5,
dans lequel une fréquence du courant de mesure alternatif (Im) est réglée sur une valeur différente d'une fréquence du premier courant de test de courant alternatif (Id1) et d'une fréquence du deuxième courant de test de courant alternatif (Id2).
